# EUROPEAN PATENT APPLICATION

(11) **EP 3 468 030 A1**
(43) Date of publication of application: **10.04.2019**
(21) Application number: 17802869.2
(22) Date of filing: 25.05.2017
(51) Int. Cl.: H02N 11/00, F02G 5/02, F02G 5/04, F28D 15/02, H01L 35/30, F01N 5/02

(54) **THERMOELECTRIC POWER GENERATION DEVICE AND THERMOELECTRIC POWER GENERATION SYSTEM**

(30) Priority: 25.05.2016 JP 2016104244
(71) Applicant: Yanmar Co., Ltd., Osaka-shi, Osaka 530-8311 (JP)
(72) Inventor: HATASAKO, Yoshika, Osaka-shi Osaka 530-8311 (JP); FUKUDOME, Jiro, Osaka-shi Osaka 530-8311 (JP); TANAKA, Yuichiro, Osaka-shi Osaka 530-0014 (JP); NAKAGAWA, Shuichi, Osaka-shi Osaka 530-8311 (JP)
(74) Representative: Boult Wade Tennant LLP
(86) International application number: PCT/JP2017/019481
(87) International publication number: WO 2017/204283

(57) **Abstract**

A thermoelectric power generation device that can improve power generation efficiency is provided. A thermoelectric power generation device (1A) of the present invention is a thermoelectric power generation device including thermoelectric elements (2) having their first sides provided to heating units (3) and their second sides provided to cooling units (4). The thermoelectric elements (2) are provided on both sides of the heating unit (3). The cooling units (4) are provided on both sides of the heating unit (3) so as to face each other across the thermoelectric elements (2).

## Description

### Technical Field

The present invention relates to a thermoelectric power generation device and a thermoelectric power generation system.

### Background Art

Patent Literature 1 (hereinafter, PTL 1) discloses a thermoelectric power generation device configured to generate electric power by using temperature difference. In the device, a heat source unit whose heat source is the exhaust gas of an engine is provided on a high-temperature side of a thermoelectric element, and a coolant container on a low-temperature side of the thermoelectric element.

### Citation List

### Patent Literature

PTL 1: Japanese Patent Application Laid-Open No. 2005-83251

### Summary of Invention

### Technical Problem

However, the thermoelectric power generation device of PTL 1 still leaves room for improvement, when it comes to improvement of power generation efficiency.

To achieve the above problem, it is an object of the present invention to provide a thermoelectric power generation device and a thermoelectric power generation system which can improve the power generation efficiency.

### Solution to Problem

A thermoelectric power generation device related to an aspect of the present invention is
a thermoelectric power generation device including thermoelectric elements having their first sides provided to heating units and their second sides provided to a cooling unit, wherein
the thermoelectric elements are provided on both sides of the heating unit, and
the cooling units are provided on both sides of the heating unit so as to face each other across the thermoelectric elements.

A thermoelectric power generation system related to an aspect of the present invention includes:
a thermoelectric power generation unit having at least one thermoelectric power generation device, and
a thermal load which consumes heat of a coolant heated by the thermoelectric power generation unit,
wherein
the thermoelectric power generation device includes thermoelectric elements having their first sides provided to a heating unit and their second sides provided to cooling units,
the thermoelectric elements are provided on both sides of the heating unit, and
the cooling units are provided on both sides of the heating unit so as to face each other across the thermoelectric elements.

### Advantageous Effects of Invention

The thermoelectric power generation device and the thennoelectric power generation system of the aspects of the present invention as described above can improve the power generation efficiency.

### Brief Description of Drawings

FIG. 1A is a diagram showing a schematic structure of a thermoelectric power generation device related to Embodiment 1 of the present invention.
FIG. 1B is a diagram showing a schematic structure of the thermoelectric power generation device related to Embodiment 1 of the present invention as viewed from behind.
FIG. 2 is a diagram showing a schematic structure of a heating unit of the thermoelectric power generation device related to Embodiment 1 of the present invention.
FIG. 3 is a diagram showing a schematic structure of a cooling unit of the thermoelectric power generation device related to Embodiment 1 of the present invention.
FIG. 4 is a schematic diagram of an electric system of a thermoelectric power generation system using the thermoelectric power generation device related to Embodiment 1 of the present invention.
FIG. 5 is a schematic diagram of a heat medium system of the thermoelectric power generation system using the thermoelectric power generation device related to Embodiment 1 of the present invention.
FIG. 6A is a diagram showing a schematic structure of a thermoelectric power generation device related to Embodiment 2 of the present invention.
FIG. 6B is a diagram showing a schematic structure of the thermoelectric power generation device related to Embodiment 2 of the present invention as viewed from behind.
FIG. 7A is a diagram showing a schematic structure of a thermoelectric power generation device related to Embodiment 3 of the present invention.
FIG. 7B is a diagram showing a schematic structure of the thermoelectric power generation device related to Embodiment 3 of the present invention as viewed from behind.
FIG. 7C is a diagram showing a schematic structure of the thermoelectric power generation device related to Embodiment 3 of the present invention as viewed in a height direction.
FIG. 8 is a diagram showing a schematic structure of a modification of the thermoelectric power generation device related to Embodiment 3 of the present invention.
FIG. 9A is a diagram showing a schematic structure of a thermoelectric power generation device related to Embodiment 4 of the present invention.
FIG. 9B is a diagram showing a schematic structure of a modification of the thermoelectric power generation device related to Embodiment 4 of the present invention.
FIG. 9C is a diagram showing a schematic structure of another modification of the thermoelectric power generation device related to Embodiment 4 of the present invention.
FIG. 10A is a diagram showing a schematic structure of a cooling unit of the thermoelectric power generation device related to Embodiment 5 of the present invention.
FIG. 10B is a diagram showing a schematic structure of a modification of the cooling unit of the thermoelectric power generation device related to Embodiment 5 of the present invention.
FIG. 11 is a diagram showing a schematic structure of a thermoelectric power generation device related to Embodiment 6 of the present invention.
FIG. 12A is a diagram showing a schematic structure of a heat transfer pipe of a thermoelectric power generation device related to Embodiment 7 of the present invention.
FIG. 12B is a diagram showing a schematic structure of the heat transfer pipe of the thermoelectric power generation device related to Embodiment 7 of the present invention as viewed in a height direction.
FIG. 13A is a diagram showing a schematic structure of a modification of the heat transfer pipe of the thermoelectric power generation device related to Embodiment 7 of the present invention.
FIG. 13B is a diagram showing a schematic structure of another modification of the heat transfer pipe of the thermoelectric power generation device related to Embodiment 7 of the present invention.
FIG. 14 is a diagram showing a schematic structure of another modification of the heat transfer pipe of the thermoelectric power generation device related to Embodiment 7 of the present invention.
FIG. 15 is a diagram showing a schematic structure of another modification of the heat transfer pipe of the thermoelectric power generation device related to Embodiment 7 of the present invention.
FIG. 16 is a diagram showing a schematic structure of another modification of the heat transfer pipe of the thermoelectric power generation device related to Embodiment 7 of the present invention.
FIG. 17A is a diagram showing a schematic structure of a heat transfer pipe of a thermoelectric power generation device related to Embodiment 8 of the present invention.
FIG. 17B is a diagram showing a schematic structure of the heat transfer pipe of the thermoelectric power generation device related to Embodiment 8 of the present invention as viewed in a height direction.
FIG. 18A is a diagram showing a schematic structure of a heat transfer pipe of a thermoelectric power generation device related to Embodiment 8 of the present invention.
FIG. 18B is a diagram showing a schematic structure of upstream side piping of the heat transfer pipe of the thermoelectric power generation device related to Embodiment 8 of the present invention.
FIG. 18C is a diagram showing a schematic structure of downstream side piping of the heat transfer pipe of the thermoelectric power generation device related to Embodiment 8 of the present invention.
FIG. 19 is a diagram showing a schematic structure of a heat transfer pipe of a thermoelectric power generation device related to Embodiment 9 of the present invention.
FIG. 20 is a diagram showing a schematic structure of a thermoelectric power generation system related to Embodiment 10 of the present invention.
FIG. 21 is a diagram showing a schematic structure of a thermoelectric power generation system related to Embodiment 11 of the present invention.
FIG. 22 is a diagram showing a schematic structure of a thermoelectric power generation system related to Embodiment 12 of the present invention.
FIG. 23 is a diagram showing a schematic structure of a thermoelectric power generation system related to Embodiment 13 of the present invention.

### Description of Embodiments

### (How the Present Invention is Made)

The thermoelectric power generation device of PTL 1 is provided with the thermoelectric element only at the bottom side of the heat source unit. As a result of intensive research by the inventors of the present invention, it was found that efficiency of utilizing a heat source unit can be improved and power generation efficiency can be improved by providing thermoelectric elements on both sides of the heat source unit. In view of this, the inventors of the present invention has reached the following invention.

A thermoelectric power generation device related to an aspect of the present invention is
a thermoelectric power generation device including thermoelectric elements having their first sides provided to a heating unit and their second sides provided to cooling units, wherein
the thermoelectric elements are provided on both sides of the heating unit, and
the cooling units are provided on both sides of the heating unit so as to face each other across the thermoelectric elements.

With this structure, both sides of the heating unit can be used for power generation by the thermoelectric elements. Therefore, power generation efficiency can be improved.

Further, the above thermoelectric power generation device may include a heat transfer pipe arranged in a passage in which a high temperature fluid flows, wherein
the heating unit and the heat transfer pipe have internal spaces communicating with each other,
the internal space of the heating unit and the internal space of the heat transfer pipe form a circulation path in which a heat medium is circulated,
the heat transfer pipe vaporizes the heat medium flowing in the circulation path by using heat of the high temperature fluid, and
the heating unit condenses the heat medium vaporized.

With this structure, the heat medium is spontaneously circulated by repeating its vaporization and condensation in the circulation path formed by the internal space of the heating unit and the internal space of the heat transfer pipe. Therefore, heat can be efficiently generated without using power for circulating the heat medium, and power generation by thermoelectric elements can be performed.

Further, the above thermoelectric power generation device may be such that the thermoelectric elements, the heating unit, and the cooling units are arranged in a direction intersecting a direction in which the heat transfer pipe is extended.

This way, downsizing of the structure of the device can be achieved.

Further, the above thermoelectric power generation device may include a first anti-deformation member which sandwiches an end portion of the heating unit and an end portion of the cooling units.

With this, thermal deformation of the cooling units due to heat from the heating unit can be suppressed or reduced. The first anti-deformation member can also suppress or reduce a problem of the thermoelectric elements being separated from the heating unit and the cooling units due to thermal deformation of the cooling units.

Further, the above thermoelectric power generation device may include a second anti-deformation member penetrating through and joining together the end portions of the cooling units facing each other.

With this, thermal deformation of the cooling units due to heat from the heating unit can be further suppressed or reduced. The second anti-deformation member can also suppress or reduce a problem of the thermoelectric elements being separated from the heating unit and the cooling units due to thermal deformation of the cooling units.

Further, the above thermoelectric power generation device may be such that the cooling units each has a plurality of uneven portions in a coolant passage in which a coolant flows.

With this structure, the heat transfer area of the coolant passage inside each cooling unit can be increased, and eddy flow can be induced. Therefore, heat transfer rate of the cooling unit can be improved.

Further, the above thermoelectric power generation device may be such that the cooling units each has a plurality of fins in a coolant passage in which a coolant flows.

With this structure, the strength of the cooling units can be improved by the fins provided in the coolant passages of the cooling units.

Further, the above thermoelectric power generation device may be such that a plurality of the heating units and the plurality of cooling units are alternately arranged with the thermoelectric elements interposed therebetween, and the cooling units are arranged on both ends.

With this structure, the power generation efficiency can be further improved. Further, by arranging the heating units and the cooling units adjacent to one another, thermal deformation of the heating units and the cooling units can be suppressed or reduced.

Further, the above thermoelectric power generation device may further include a plurality of heat transfer pipes arranged in a passage in which the high temperature fluid flows, wherein
the heating units and the heat transfer pipes have internal spaces communicating with one another,
the internal spaces of the heating units and the internal spaces of the heat transfer pipes form a circulation path in which a heat medium is circulated,
the internal spaces of the plurality of the heat transfer pipes are in communication through a pressure equalizer,
the heat transfer pipes vaporize the heat medium flowing in the circulation path by using heat of the high temperature fluid, and
each of the heating units condenses the heat medium vaporized.

With this structure, the pressure in the plurality of heat transfer pipes can be equalized by the pressure equalizer. Therefore, the heat medium flowing in the internal spaces of the heat transfer pipes can be efficiently circulated.

Further, the above thermoelectric power generation device may include a heat transfer pipe arranged in a passage in which a high temperature fluid flows, wherein
the heating units and the heat transfer pipe have internal spaces communicating with each other,
the internal spaces of the heating units and the internal space of the heat transfer pipe form a circulation path in which a heat medium is circulated,
the plurality of heating units share the heat transfer pipe,
the heat transfer pipes vaporize the heat medium flowing in the circulation path by using heat of the high temperature fluid, and
each of the heating units condenses the heat medium vaporized.

With this structure, each of the heating units can be equally heated by sharing the heat transfer pipe amongst the plurality of the heating units.

The above thermoelectric power generation device may be such that the heat transfer pipe includes a plurality of pipes, and a collecting pipe joining the plurality of pipes.

With this structure, the pressure in the plurality of pipes can be equalized by the collecting pipe. Therefore, the heat exchanger duty amongst the plurality of pipes can be improved.

The above thermoelectric power generation device may be such that the heat transfer pipe is arranged so as to be inclined relative to a direction in which the high temperature fluid flows.

With this structure, the high temperature fluid easily contacts the entire heat transfer pipe, and the heat transfer rate of the heat transfer pipe can be improved.

The above thermoelectric power generation device may be such that the plurality of pipes are offset relative to a height direction of the heat transfer pipe, as viewed from a direction in which the high temperature fluid flows.

With this structure, an area in which the plurality of pipes overlap as viewed from the direction in which the high temperature fluid flows can be reduced. With this structure, the high temperature fluid easily contacts the plurality of pipes, and the heat transfer rate of the heat transfer pipe can be improved.

The above thermoelectric power generation device may be such that the plurality of pipes respectively have bent portions, and
the bent portions of the plurality of pipes have different bend radii.

With this structure, an area in which the plurality of pipes overlap as viewed from the direction in which the high temperature fluid flows can be reduced. With this structure, the high temperature fluid easily contacts the plurality of pipes, and the heat transfer rate of the heat transfer pipe can be improved.

The above thermoelectric power generation device may be such that the heat transfer pipe has a blackened outer surface.

With this structure, recovery of radiant heat can be improved on the outer surface of the heat transfer pipe.

The above thermoelectric power generation device may be such that a wick is provided on an inner wall of the heat transfer pipe.

With this structure, circulation of the heat medium inside the heat transfer pipe can be induced.

The above thermoelectric power generation device may be such that a groove is provided on an inner wall of the heat transfer pipe.

With this structure, circulation of the heat medium inside the heat transfer pipe can be induced.

The above thermoelectric power generation device may be such that the heat transfer pipe is provided in a part of a passage having a guide vane, and
the high temperature fluid flowing in the passage is directed towards the heat transfer pipe by the guide vane.

With this structure, flow rate of the high temperature fluid flowing towards the heat transfer pipe can be increased by the guide vane.

A thermoelectric power generation device related to another aspect of the present invention is
a thermoelectric power generation device including thermoelectric elements having their first sides provided to heating units and their second sides provided to a cooling unit, and
a partition defining two passages in which a high temperature fluid flows, wherein
the thermoelectric elements, the cooling unit, and the heating units are provided between the two passages;
the thermoelectric elements are provided on both sides of the cooling unit; and
the heating units are provided on both sides of the cooling unit so as to face each other across the thermoelectric element.

With this structure, the heating units provided on both sides of the cooling unit so as to face each other across the thermoelectric elements can be heated by feeding the high temperature fluid in the two passages. Hence, an increase in the output can be achieved.

A thermoelectric power generation system related to an aspect of the present invention includes:
a thermoelectric power generation unit having at least one thermoelectric power generation device, and
a thermal load which consumes heat of a coolant heated by the thermoelectric power generation unit,
wherein
the thermoelectric power generation device includes thermoelectric elements having their first sides provided to a heating unit and their second sides provided to cooling units,
the thermoelectric elements are provided on both sides of the heating unit, and
the cooling units are provided on both sides of the heating unit so as to face each other across the thermoelectric elements.

With this structure, both sides of the heating unit can be used for power generation by the thermoelectric elements. Therefore, power generation efficiency can be improved. Further, since the heat of the coolant heated by the thermoelectric power generation unit can be consumed by the thermal load, efficiency in utilization of energy can be improved.

The following describes embodiments with reference to attached drawings. In each of the drawings, elements are exaggerated for the sake of easier understanding.

### (Embodiment 1)

### [Overall Structure]

An overall structure of a thermoelectric power generation device related to Embodiment 1 is described.

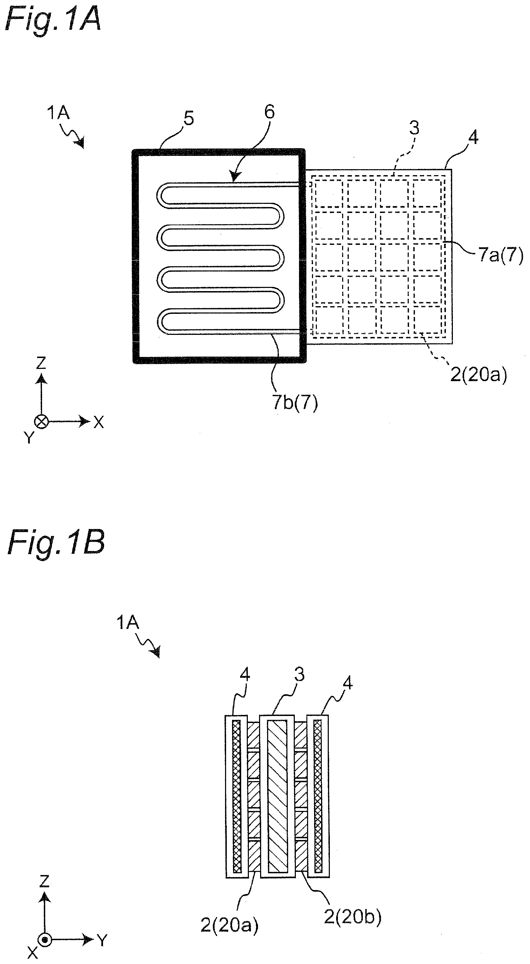

FIG. 1A shows a schematic structure of a thermoelectric power generation device 1A related to Embodiment 1. The directions X, Y, and Z in FIG. 1A indicate the longitudinal direction, lateral direction, and the height direction of the thermoelectric power generation device 1A, respectively. The longitudinal direction, the lateral direction, and the height direction mean the length direction, short direction, and the up-down direction of the thermoelectric power generation device 1A, respectively. FIG. 1B is a diagram showing a schematic structure of the thermoelectric power generation device 1A as viewed from behind (in X direction).

As shown in FIG. 1A and FIG. 1B, a thermoelectric power generation device 1A includes thermoelectric elements 2 having their first sides provided to heating units 3 and their second sides provided to cooling unit 4. The thermoelectric elements 2 are provided on both sides of the heating unit 3, and the cooling units 4 are provided on both sides of the heating unit 3 so as to face each other across the thermoelectric elements 2. In Embodiment 1, the heating unit 3 is connected to a heat transfer pipe 6 arranged in a passage 5 in which a high temperature fluid flows.

### <Thermoelectric Element>

Each of the thermoelectric element 2 is an element having two surfaces, i.e., a first side (high-temperature side) to be provided on the heating unit 3, and a second side (low-temperature side) to be provided on the cooling unit 4. The thermoelectric element 2 generates power by utilizing a temperature difference caused by having its first side heated by the heating unit 3 while its second side cooled by the cooling unit 4. The thickness of the thermoelectric element 2 is designed to be smaller than the size (width) of the first side and the second side of the thermoelectric element 2. Specifically, the thermoelectric element 2 is formed in a plate shape. In Embodiment 1, thermoelectric modules 20a and 20b each having a plurality of serially connected thermoelectric elements 2 are attached to both sides of the heating unit 3. Specifically, on both sides of the heating unit 3, the thermoelectric modules 20a, 20b each having 20 thermoelectric elements 2 of four columns x five rows are attached. The number of thermoelectric elements 2 is not limited to this. For example, the thermoelectric power generation device 1A may have one thermoelectric element 2 attached to each of the both sides of the heating unit 3.

### <Heating Unit>

The heating unit 3 is made of a metal material with excellent thermal conductivity. The heating unit 3 is formed in a plate shape, which contacts first sides of the thermoelectric elements 2. The heating unit 3 is connected to the heat transfer pipe 6. The heating unit 3 and the heat transfer pipe 6 have internal spaces 7a, 7b communicating with each other. In the internal space 7a of the heating unit 3 and the internal space 7b of the heat transfer pipe 6, a heat medium is enclosed. Further, the internal space 7a of the heating unit 3 and the internal space 7b of the heat transfer pipe 6 form a circulation path 7 in which the heat medium is circulated.

The heat transfer pipe 6 is arranged in the passage 5 and vaporizes the heat medium flowing in the internal space 7b which is a part of the circulation path 7, by using the heat of the high temperature fluid flowing in the passage 5. That is, the heat transfer pipe 6 functions as a vaporizing unit for vaporizing the heat medium. The heating unit 3 condenses the heat medium vaporized in the internal space 7b of the heat transfer pipe 6. That is, the heating unit 3 functions as a condensing unit for condensing the heat medium. In Embodiment 1, water is used as the heat medium. Further, the passage 5 is an exhaust gas duct of an engine in which high-temperature exhaust gas flows. In the passage 5, the high temperature fluid flows in a direction towards the paper surface of FIG. 1A, i.e., in Y direction. The passage 5 may be, for example, a high-temperature environment such as an industrial waste furnace or a biomass boiler, or a radiation field not requiring convection, in addition to the exhaust gas duct of an engine.

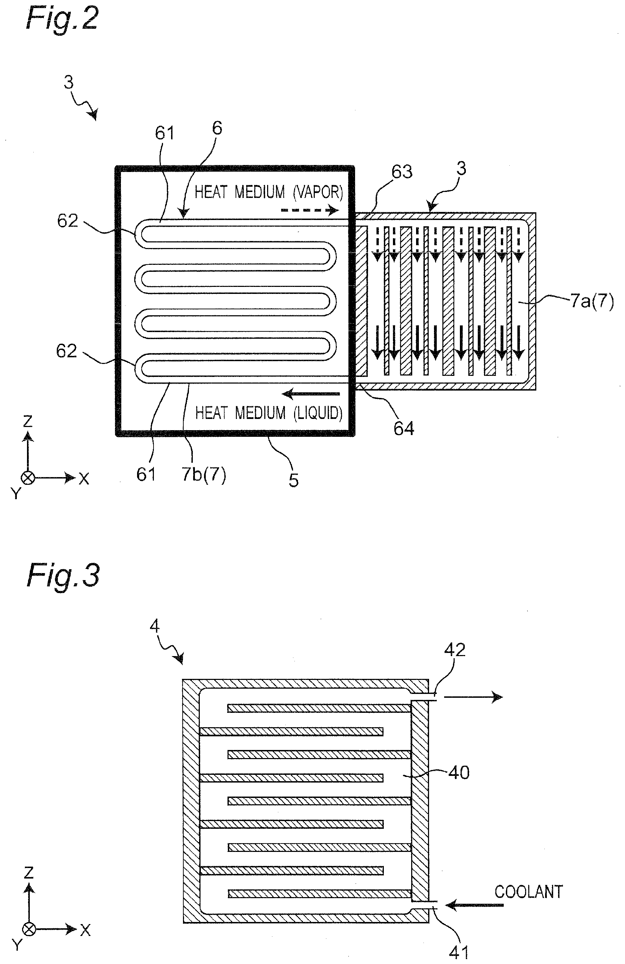

FIG. 2 shows a schematic structure of the heating unit 3 and the heat transfer pipe 6 of the thermoelectric power generation device 1A. As shown in FIG. 2, the heat transfer pipe 6 is structured so as to have a large contact area with the high temperature fluid flowing in the passage 5, when viewed in the direction in which the high temperature fluid flows, i.e., the Y direction. Specifically, the heat transfer pipe 6 has a plurality of tubular members 61 extending in the X direction and a plurality of bent portions 62 connecting the tubular members 61 to each other, as viewed from the Y direction. The plurality of tubular members 61 are arranged with a predetermined interval in the Z direction and their end portions are connected through the bent portions 62, when viewed in the Y direction. With the plurality of tubular members 61 connected through the bent portions 62 as described, the heat transfer pipe 6 forms a continuous pipe having a plurality of bent portions.

In the internal space 7a of the heating unit 3, a heat medium passages are formed in such a manner that the heat medium spreads throughout the entire heating surface of the thermoelectric elements 2. Specifically, as shown in FIG. 2, a plurality of heat medium passages extending in the Z direction are formed in the internal space 7a of the heating unit 3. The heat medium passages in the internal space 7a of the heating unit 3 may be, for example, inclined towards the X direction, as long as the heat medium flows in the direction of gravity.

### <Circulation Path>

The circulation path 7 is formed through the internal space 7a of the heating unit 3 and the internal space 7b of the heat transfer pipe 6. The heat medium circulates in the internal space 7a of the heating unit 3 and the internal space 7b of the heat transfer pipe 6. Specifically, when the heat transfer pipe 6 is heated by the high temperature fluid flowing in the passage 5, the liquid heat medium flowing in the heat transfer pipe 6 is turned into vapor. In other words, the heat medium is vaporized in the internal space 7b of the heat transfer pipe 6 and the phase of the heat medium changes from liquid to gas. The vapor is discharged from an opening end portion 63 in a high position of the heat transfer pipe 6 to the heat medium passage in the internal space 7a of the heating unit 3. The vapor discharged into the heat medium passage in the internal space 7a of the heating unit 3 falls in the direction of gravity while being poured onto the heating surface of the heating unit 3, and is condensed by radiating heat from the heating surface to heat the thermoelectric elements 2. In other words, the phase of the heat medium changes from gas to liquid in the internal space 7a of the heating unit 3. The heat medium condensed flows from an open end portion 64 in a low position of the heat transfer pipe 6 into the heat medium passage in the internal space 7b of the heat transfer pipe 6. The heat medium having flowed into the internal space 7b of the heat transfer pipe 6 is again heated by the high temperature fluid flowing into the passage 5, and the phase of the heat medium is changed from liquid to gas. As described, the heat medium spontaneously circulates in the circulation path 7 formed by the internal space 7a of the heating unit 3 and the internal space 7b of the heat transfer pipe 6. In other words, by using the phase change of the heat medium, the heat medium is repeatedly circulated in the circulation path 7 formed by the internal space 7a of the heating unit 3 and the internal space 7b of the heat transfer pipe 6, without power of a pump and the like.

### <Cooling Unit>

The cooling units 4 are each made of a metal material with excellent thermal conductivity. The cooling units 4 are formed in a plate shape, which contact the second sides of the thermoelectric elements 2. Further, inside each of the cooling units 4, a coolant passage in which a coolant flows is formed.

FIG. 3 shows a schematic structure of the cooling unit 4 of the thermoelectric power generation device 1A. As shown in FIG. 3, inside the cooling unit 4, a plate-shape coolant passage 40 is formed in such a manner that the coolant is spread throughout the entire cooling surface of the cooling unit 4 which contacts the thermoelectric element 2. Specifically, the coolant passage 40 has a plurality of passages extending in the X direction, which are connected with one another. The coolant passage 40 is provided with a coolant inflow pipe 41 on its low side, and a coolant discharge pipe 42 on its high side. The coolant having flowed from the coolant inflow pipe 41 into the coolant passage 40 cools the cooling surface in contact with the second side of the thermoelectric element 2, and then discharged from the coolant discharge pipe 42. Although the coolant passage 40 in Embodiment 1 is formed in a plate shape such that the coolant spreads throughout the entire cooling surface in contact with the thermoelectric element 2, the shape of the coolant passage 40 is not limited as long as the second side of the thermoelectric element 2 is entirely and evenly cooled. Further, the plurality of passages of the coolant passage 40 inside the cooling unit 4 may extend not only in the X direction but also in the Z direction. In Embodiment 1, water is used as the coolant.

### <Electric System>

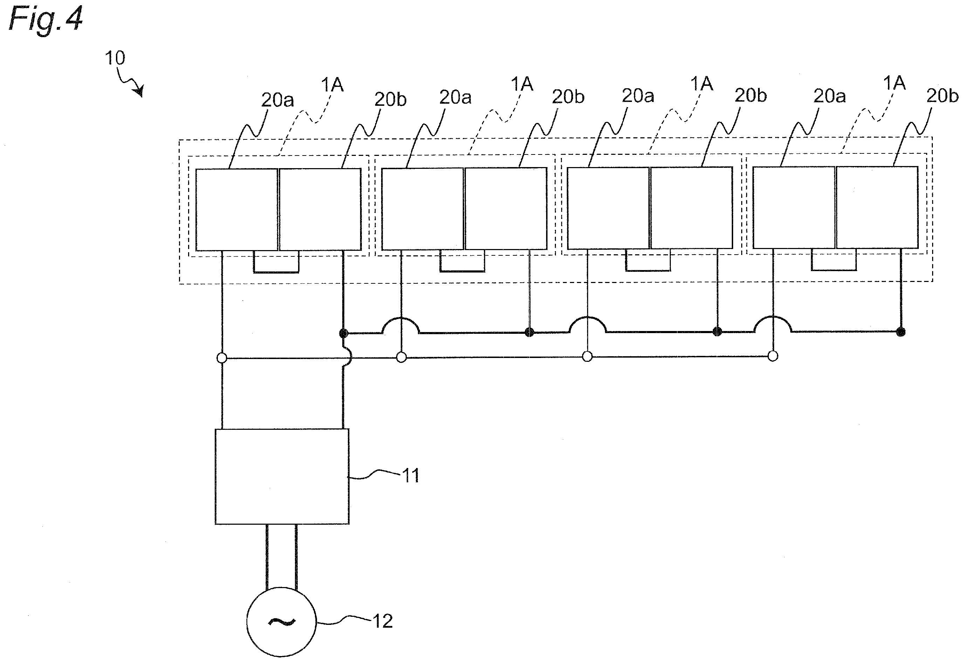

FIG. 4 is a schematic diagram of an electric system of a thermoelectric power generation system 10 using the thermoelectric power generation device 1A. As shown in FIG. 4, the thermoelectric power generation system 10 includes: four thermoelectric power generation devices 1A, an inverter 11, and an electric load 12. In the thermoelectric power generation system 10, the four thermoelectric power generation devices 1A are connected in parallel. The four thermoelectric power generation devices 1A connected in parallel are connected to the inverter 11. The inverter 11 is connected to the electric load 12. In the thermoelectric power generation system 10, electric power generated by the four thermoelectric power generation devices 1A is supplied to the electric load 12 through the inverter 11.

### <Heat Medium System>

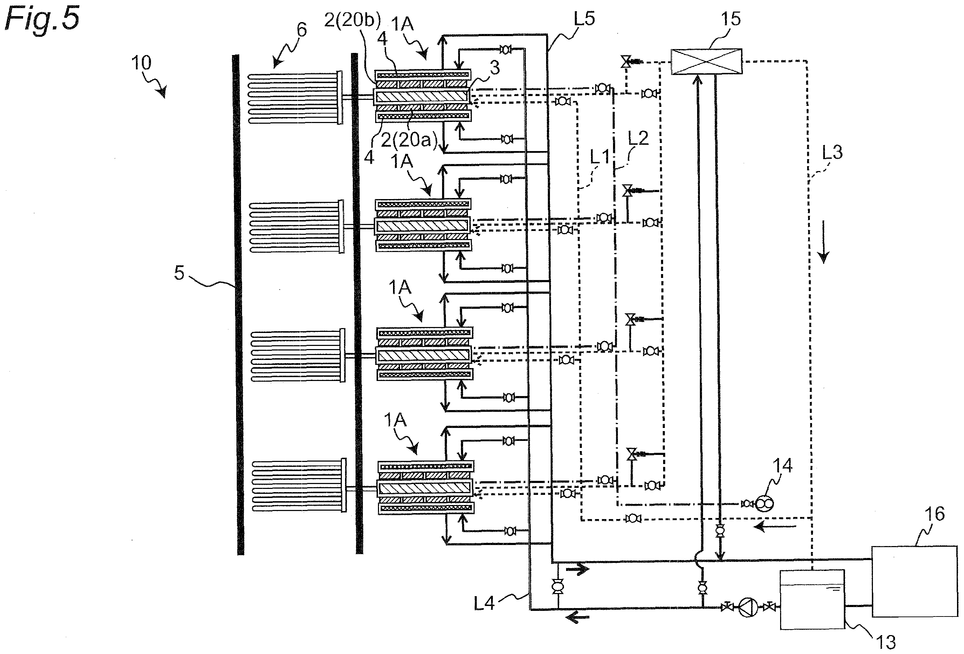

FIG. 5 is a schematic diagram of a heat medium system of a thermoelectric power generation system 10 using the thermoelectric power generation device 1A. In FIG. 5, the dotted line and the one dot chain line indicate the line of the heat medium, and the solid line indicates the line of the coolant. First, a flow of the heat medium is described. As shown in FIG. 5, the heat medium lines L1, L2, L3 are connected to the heating units 3 of the thermoelectric power generation devices 1A. To the heat medium lines L1, L2, and L3, valves are provided respectively. While the heat medium spontaneously circulates inside the heating unit 3, the heat medium lines L1, L2, L3 are closed. The valve provided to the heat medium line L3 is a pressure valve.

The heat medium line L1 is a line for filling water to become the heat medium. To supply the heat medium inside the heating unit 3, the valve of the heat medium line L1 is opened to supply the heat medium from a tank 13 into the heating unit 3, through the heat medium line L1.

The heat medium line L2 is a line for evacuation using a vacuum pump 14. Evacuation is performed by using the vacuum pump 14 through the heat medium line L2, while the heating unit 3 has no heat medium. After the evacuation, the heat medium in the tank 13 is supplied inside the heating unit 3 through the heat medium line L1.

The heat medium line L3 is a line for discharging the heat medium inside the heating unit 3 to the tank 13. When the vapor pressure inside the heating unit 3 becomes higher than the tolerance of the pressure valve of the heat medium line L3, the pressure valve opens and the vapor inside the heating unit 3 is discharged to the heat medium line L3. The heat medium discharged from the heating unit 3 flows in the heat medium line L3, and is discharged to the tank 13 through a heat exchanger 15. Since water is used as the heat medium and as the coolant in Embodiment 1, the coolant and the heat medium can be stored in the tank 13.

Next, a flow of the coolant is described. As shown in FIG. 5, the coolant flows from the tank 13 to the cooling unit 4 through a coolant line L4, by using a pump and the like. The coolant having flowed into the cooling unit 4 flows to a cooling installation 16 through a coolant line L5. The cooling installation 16 is, for example, a cooling tower for cooling the coolant. The coolant cooled in the cooling installation 16 is stored in the tank 13.

In Embodiment 1, the limit temperature for using the thermoelectric power generation devices 1A is, for example, 200°C. The heating temperature in the heating unit 3 is 180°C, and the temperature of the coolant flowing in the cooling unit 4 is 30°C.

### [Effects]

The thermoelectric power generation device 1A related to Embodiment 1 brings about the following effects.

In the thermoelectric power generation device 1A, the thermoelectric elements 2 are provided on both sides of the heating unit 3, and the cooling units 4 are provided on both sides of the heating unit 3 so as to face each other across the thermoelectric elements 2. With this structure, both sides of the heating unit 3 can be used for power generation by the thermoelectric elements 2. Therefore, power generation efficiency can be improved.

Since the cooling units 4 are provided on both sides of the heating unit 3 in the thermoelectric power generation device 1, the temperature difference on both sides of the heating unit 3 can be made smaller. Therefore, thermal deformation of the heating unit 3 can be suppressed or reduced. Therefore, thermal strain of the thermoelectric modules 20a, 20b caused by thermal deformation of the heating unit 3 can be suppressed or reduced. In a structure where a thermoelectric element 2 and a cooling unit 4 is provided only on one side (a single side) of the heating unit 3, the other side of the heating unit 3 having not thermoelectric element 2 or cooling unit 4 is kept in a high temperature state as compared to the one side of the heating unit 3. Due to this, thermal deformation takes place on the other side of the heating unit 3, which may lead to a damage in the heating unit 3. The thermoelectric power generation device 1A however has the cooling units 4 on both sides of the heating unit 3, and hence damages to the heating unit3 due to thermal deformation can be suppressed or reduced.

With the thermoelectric power generation device 1A, the heat medium can be circulated by phase changes in the circulation path 7 formed by the internal space 7a in the heating unit 3 and the internal space 7b in the heat transfer pipe 6. Therefore, the heat medium can be circulated without a power from a pump and the like, and reduction of costs and downsizing of the device can be achieved. Further, by using water as the heat medium and the coolant, the tank 13 can be used for storing both the heat medium and the coolant. Therefore, further reduction of costs and downsizing of the device can be achieved.

It should be noted that Embodiment 1 deals with a thermoelectric power generation system 10 having four thermoelectric power generation devices 1A; however, the present invention is not limited to this, as long as the thermoelectric power generation system 10 includes at least one thermoelectric power generation device 1A.

Although Embodiment 1 adopts water as the heat medium and the coolant, the present invention is not limited to this. The heat medium and the coolant may be different. Any heat medium may be adopted provided that the heat medium can change its phase between gas and liquid in the circulation path 7. Any given coolant may be adopted provided that cooling is possible.

Although Embodiment 1 deals with an example where the limit temperature for using the thermoelectric power generation devices 1A is 200°C, the present invention is not limited to this. For example, the limit temperature for using the thermoelectric power generation device 1A may be increased by forming the heating unit 3 with a highly heat resistant material. With such a structure, the heating temperature of the heating unit 3 and the temperature of the coolant can be increased.

### (Embodiment 2)

### [Overall Structure]

A thermoelectric power generation device related to Embodiment 2 of the present invention is described. It should be noted that Embodiment 2 mainly describes differences from Embodiment 1. In Embodiment 2, the same symbols are given to structures identical or similar to those of Embodiment 1. Further, the description of Embodiment 2 omits descriptions which overlaps with that of Embodiment 1.

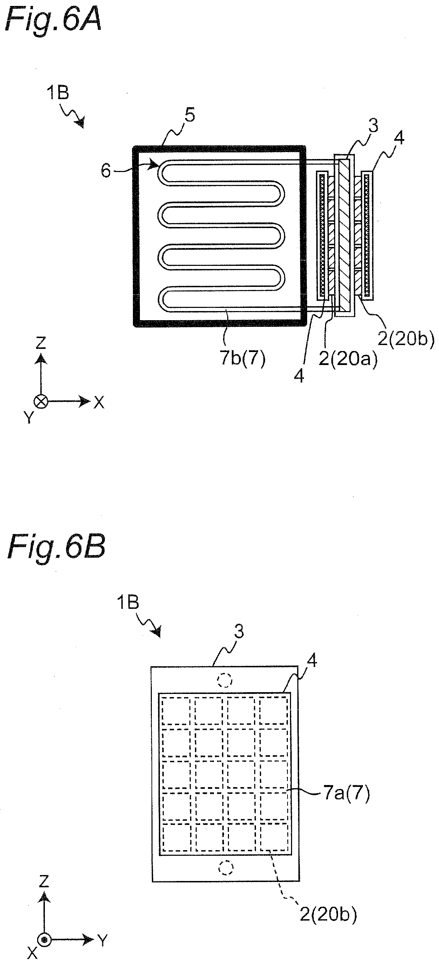

FIG. 6A shows a schematic structure of a thermoelectric power generation device IB related to Embodiment 2. FIG. 6B is a diagram showing a schematic structure of the thermoelectric power generation device 1B as viewed from behind (in X direction).

Embodiment 2 is different from Embodiment 1 in that the thermoelectric elements 2, the heating unit 3, and the cooling units 4 extend in a direction intersecting the direction in which the heat transfer pipe 6 is extended.

As shown in FIG. 6A and FIG. 6B, in the thermoelectric power generation device 1B, the thermoelectric elements 2, the heating unit 3 and the cooling units 4 are arranged in a direction (Y direction) which intersects with the direction (X direction) in which the heat transfer pipe 6 is extended. Specifically, the thermoelectric elements 2, the heating unit 3, and the cooling units 4 are arranged along the outer surface of an exhaust gas duct serving as the passage 5. In Embodiment 2, the thermoelectric elements 2, the heating unit 3, and the cooling units 4 extend in a direction perpendicularly intersecting the direction in which the heat transfer pipe 6 is extended.

### [Effects]

The thermoelectric power generation device 1B related to Embodiment 2 brings about the following effects.

With the thermoelectric power generation device 1B, the thermoelectric elements 2, the heating unit 3, and the cooling units 4 are arranged in a direction (Y direction) which intersects with the direction (X direction) in which the heat transfer pipe 6 is extended. Hence, the dimension relative to the X direction can be reduced. Therefore, downsizing of the structure of the device can be achieved.

Although Embodiment 2 deals with a case where, the thermoelectric elements 2, the heating unit 3, and the cooling units 4 extend in a direction perpendicularly intersecting the direction in which the heat transfer pipe 6 is extended, the present invention is not limited to this. The intersecting angle of the direction in which the thermoelectric elements 2, the heating unit 3, and the cooling units 4, relative to the angle in which the heat transfer pipe 6 is extended may be changed according to the shape and the like of the passage 5. For example, the thermoelectric elements 2, the heating unit 3, and the cooling units 4 may be further inclined towards the side of the passage 5, so as to intersect, at an obtuse angle the direction (X direction) in which the heat transfer pipe 6 is extended. Alternatively, the thermoelectric elements 2, the heating unit 3, and the cooling units 4 may be inclined to the side opposite to the passage 5, so as to intersect, at an acute angle, the direction (X direction) in which the heat transfer pipe 6 is extended.

### (Embodiment 3)

### [Overall Structure]

A thermoelectric power generation device related to Embodiment 3 of the present invention is described. It should be noted that Embodiment 3 mainly describes differences from Embodiment 1. In Embodiment 3, the same symbols are given to structures identical or similar to those of Embodiment 1. Further, the description of Embodiment 3 omits descriptions which overlaps with that of Embodiment 1.

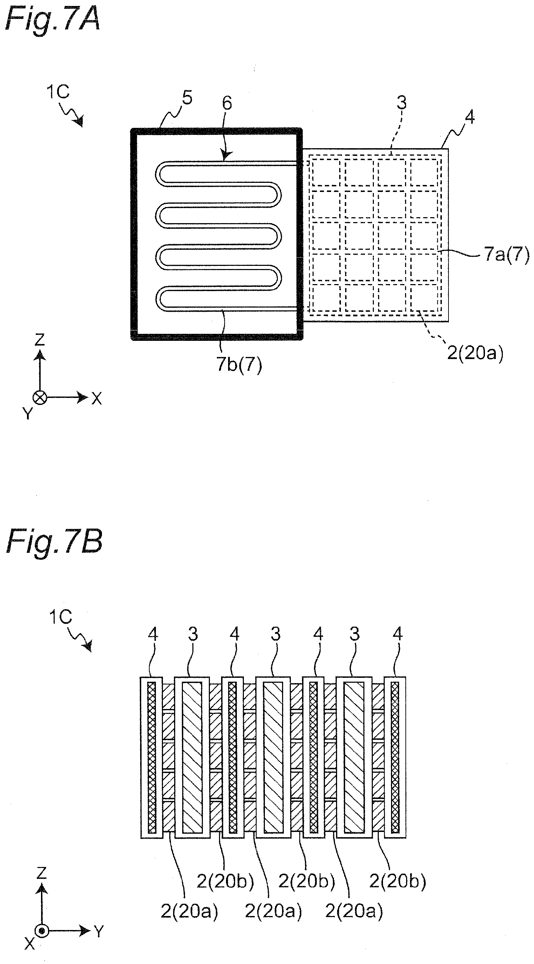

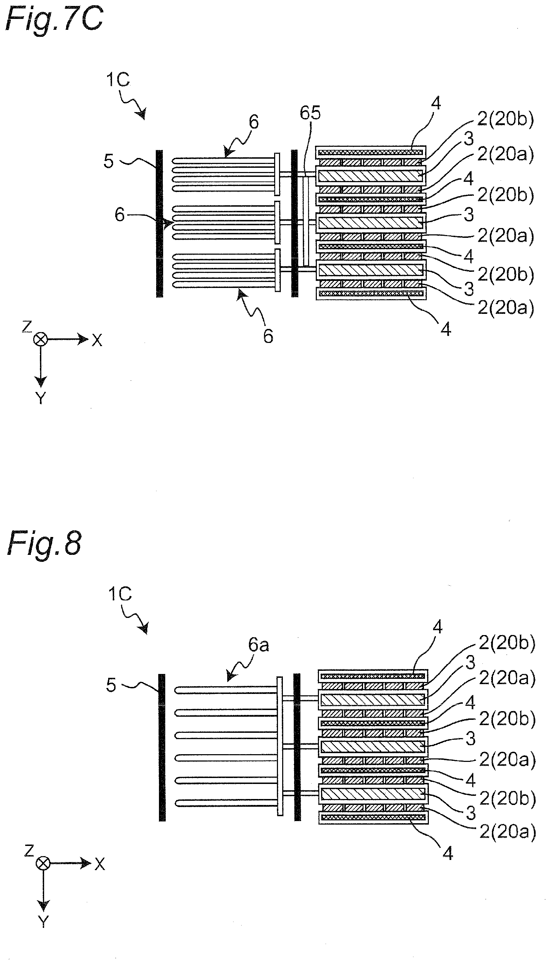

FIG. 7A shows a schematic structure of a thermoelectric power generation device 1C related to Embodiment 3. FIG. 7B is a diagram showing a schematic structure of the thermoelectric power generation device 1C as viewed from behind (in X direction). FIG. 7C is a diagram showing a schematic structure of the thermoelectric power generation device 1C when viewed in the height direction (in Z direction).

Embodiment 3 differs from Embodiment 1 in that a plurality of heating units 3 and a plurality of cooling units 4 are alternately arranged with the thermoelectric elements 2 interposed therebetween, and the cooling units 4 are arranged on both ends.

As shown in FIG. 7A, FIG. 7B, and FIG. 7C, the thermoelectric power generation device 1C has the plurality of heating units 3 and the plurality of cooling units 4 alternately arranged with the thermoelectric elements 2 interposed therebetween. On both ends of the thermoelectric power generation device 1C, the cooling units 4 are arranged. In Embodiment 3, three heating units 3 and four cooling units 4 are alternately arranged with the thermoelectric elements 2 interposed therebetween.

Further, in Embodiment 3, heat transfer pipes 6 are connected to the plurality of heating units 3 as shown in FIG. 7C. The thermoelectric power generation device 1C has a pressure equalizer 65 which communicates the internal spaces 7b of the heat transfer pipes 6. By connecting the internal spaces 7b of the plurality of heat transfer pipes 6 to the pressure equalizer 65, the pressures in the internal spaces 7b of the heat transfer pipes 6 are equalized.

### [Effects]

The thermoelectric power generation device 1C related to Embodiment 3 brings about the following effects.

The thermoelectric power generation device 1C enables arrangement of many thermoelectric elements 2 for a structure of a pair of the heating unit 3 and the cooling unit 4. Therefore, with the thermoelectric power generation device 1C, the power generation efficiency can be improved and an increase in the output can be achieved.

Since the plurality of heating units 3 and the plurality of cooling units 4 are alternately arranged in the thermoelectric power generation device 1C, thermal deformation of the heating units 3 and the cooling units 4, i.e., warping can be suppressed or reduced with the presence by the presence of the adjacent heating unit 3 and the cooling unit 4.

Further, internal spaces 7b of the plurality of heat transfer pipes 6 can be connected through the pressure equalizer 65 in the thermoelectric power generation device 1C, the pressures of the heat transfer pipes 6 can be equalized. This way, the temperature inside each of the heat transfer pipes 6 can be equalized.

Although Embodiment 3 deals with a structure in which the plurality of heating units 3 are each provided with heat transfer pipes 6, respectively, i.e., a plurality of heat transfer pipes 6 are provided, the present invention is not limited to this. FIG. 8 shows a schematic structure of a modification of the thermoelectric power generation device 1C related to Embodiment 3. As shown in FIG. 8, the plurality of heating units 3 may share a single heat transfer pipe 6a. With such a structure, the heating temperature of the plurality of heating units 3 can be equalized.

Although Embodiment 3 adopts a structure including three heating units 3 and four cooling units 4, the number of heating units 3 and the number of cooling units 4 are not limited to these, as long as two or more heating units 3 and three or more cooling units 4 are alternately arranged with the thermoelectric elements 2 interposed therebetween, in the thermoelectric power generation device 1C.

### (Embodiment 4)

### [Overall Structure]

A thermoelectric power generation device related to Embodiment 4 of the present invention is described. It should be noted that Embodiment 4 mainly describes differences from Embodiment 1. In Embodiment 4, the same symbols are given to structures identical or similar to those of Embodiment 1. Further, the description of Embodiment 4 omits descriptions which overlaps with that of Embodiment 1.

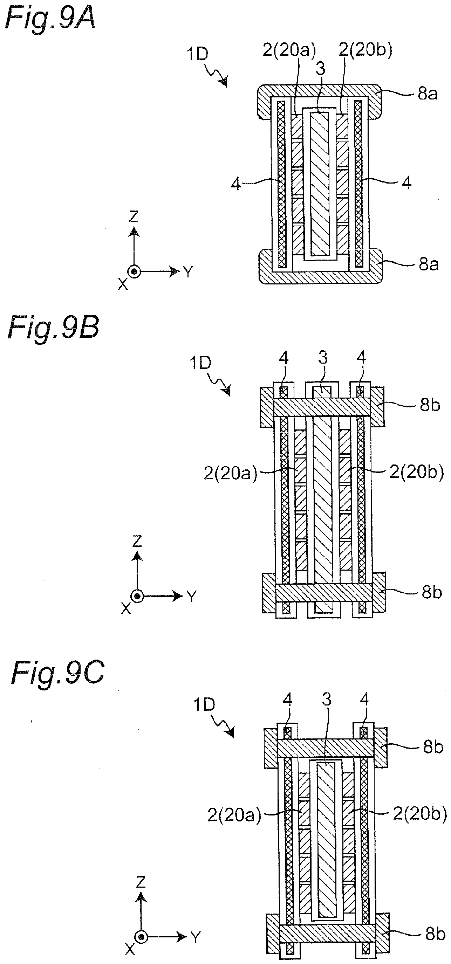

FIG. 9A shows a schematic structure of a thermoelectric power generation device 1D related to Embodiment 4. FIG. 9A is a diagram showing a schematic structure of the thermoelectric power generation device as viewed from behind.

Embodiment 4 is different from Embodiment 1 in that a first anti-deformation member 8a for suppressing or reducing thermal deformation of the cooling units 4 is provided.

As shown in FIG. 9A, the thermoelectric power generation device 1D has a first anti-deformation members 8a each of which sandwiches an end portion of the heating unit 3 and an end portions of the cooling units 4. Each of the first anti-deformation members 8a is a member for suppressing or reducing thermal deformation (warping) of the cooling units 4 due to heat of the heating unit 3. The first anti-deformation member 8a sandwiches the end portion of the heating units 3 and the end portions of the cooling units 4 provided to both sides of the heating unit 3 so as to face each other across the thermoelectric elements 2.

### [Effects]

The thermoelectric power generation device 1D related to Embodiment 4 brings about the following effects.

With the thermoelectric power generation device 1D, thermal deformation of the cooling units 4 due to heat from the heating unit 3 can be suppressed or reduced. Thus, it is possible to suppress or reduce a problem of the heating unit 3 and the cooling units 4 being separated from the thermoelectric elements 2 due to thermal deformation of the cooling units 4.

Although Embodiment 4 deals with a case where the first anti-deformation member sandwiches the end portion of the heating unit 3 and the end portions of the cooling units 4, the present invention is not limited to this. FIG. 9B shows a schematic structure of a modification of the thermoelectric power generation device 1D related to Embodiment 4. As shown in FIG. 9B, the thermoelectric power generation device 1D may have second anti-deformation members 8b each of which penetrates through and joins together an end portion of the heating unit 3 and an end portions of the cooling units 4 facing each other across the heating unit 3. For example, each of the second anti-deformation members 8b is a bolt. In the modification of the thermoelectric power generation device 1D, the second anti-deformation members 8b each penetrates through the end portion of the heating unit 3 and the end portions of the cooling units 4, and is screwed with nuts to join together the end portion of the heating unit 3 and the end portions of the cooling units 4. Alternatively, a screw portion may be provided to the cooling units 4 and the heating unit 3, and the second anti-deformation member 8b may be screwed with the screw portion provided inside the cooling units 4 and the heating unit 3 to join together the end portion of the heating unit 3 and the end portions of the cooling units 4. Thermal deformation of the cooling units 4 can be suppressed or reduced also with this structure.

FIG. 9C shows a schematic structure of another modification of the thermoelectric power generation device 1D related to Embodiment 4. As shown in FIG. 9C, the second anti-deformation member 8b may be structured so as to penetrate through only the end portions of the cooling units 4 facing each other, without penetrating through the heating unit 3. With this, heat of the heating unit 3 can be suppressed or reduced from being transferred to the cooling units 4 through the second anti-deformation member 8b. The thermoelectric power generation device 1D may adopt in combination the first anti-deformation member 8a and the second anti-deformation member 8b. Further, the first anti-deformation member 8a and the second anti-deformation member 8b may be provided to one end portions of the heating unit 3 and the cooling units 4.

### (Embodiment 5)

### [Overall Structure]

A thermoelectric power generation device related to Embodiment 5 of the present invention is described. It should be noted that Embodiment 5 mainly describes differences from Embodiment 1. In Embodiment 5, the same symbols are given to structures identical or similar to those of Embodiment 1. Further, the description of Embodiment 5 omits descriptions which overlaps with that of Embodiment 1.

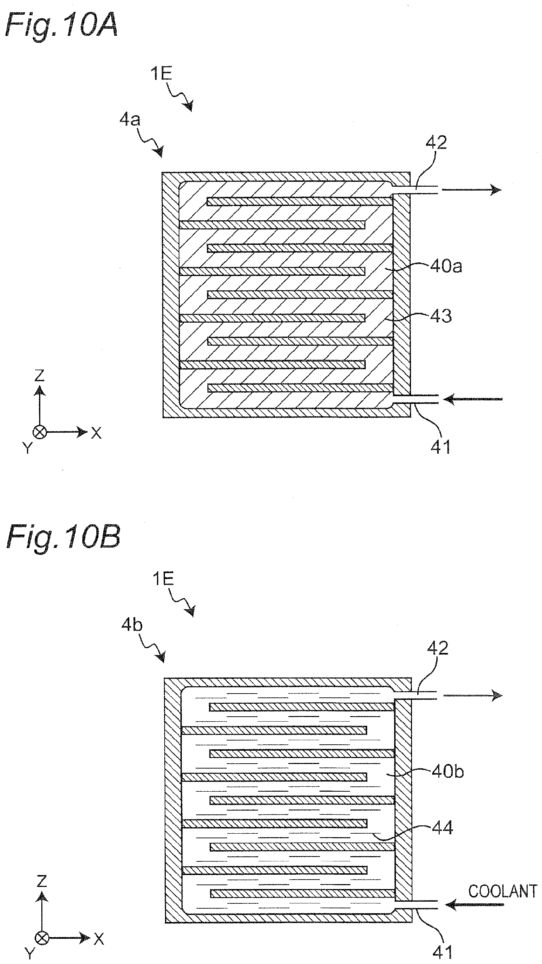

FIG. 10A shows a schematic structure of a cooling unit 4 of a thermoelectric power generation device 1E related to Embodiment 5.

Embodiment 5 is different from Embodiment 1 in that the coolant passage 40a has on its inner wall a plurality of uneven portions 43.

As shown in FIG. 10A, the cooling unit 4 of the thermoelectric power generation device IE has a plurality of uneven portions 43 on the inner wall of the coolant passage 40a in which the coolant flows.

### [Effects]

The thermoelectric power generation device IE related to Embodiment 5 brings about the following effects.

With the thermoelectric power generation device 1E, the heat transfer area can be increased, by the uneven portions provided to the inner wall of the coolant passage 40a in which the coolant flows. Further, with the thermoelectric power generation device 1E, eddy flow can be induced by having the coolant flow in the coolant passage 40a having the uneven portions 43. Therefore, heat transfer rate can be improved.

Although Embodiment 5 deals with a case of having the uneven portions 43 on the inner wall of the coolant passage 40a in which the coolant flows, the present invention is not limited to this. FIG. 10B shows a schematic structure of a modification of the cooling unit 4b of the thermoelectric power generation device 1E related to Embodiment 5. As shown in FIG. 10B, the cooling unit 4b has a plurality of fins 44 on the inner wall of the coolant passage 40b. The plurality of fins 44 are each formed in a plate shape extended in the X direction. With this structure, the strength of the cooling unit 4 can be improved.

### (Embodiment 6)

### [Overall Structure]

A thermoelectric power generation device related to Embodiment 6 of the present invention is described. It should be noted that Embodiment 6 mainly describes differences from Embodiment 1. In Embodiment 6, the same symbols are given to structures identical or similar to those of Embodiment 1. Further, the description of Embodiment 6 omits descriptions which overlaps with that of Embodiment 1.

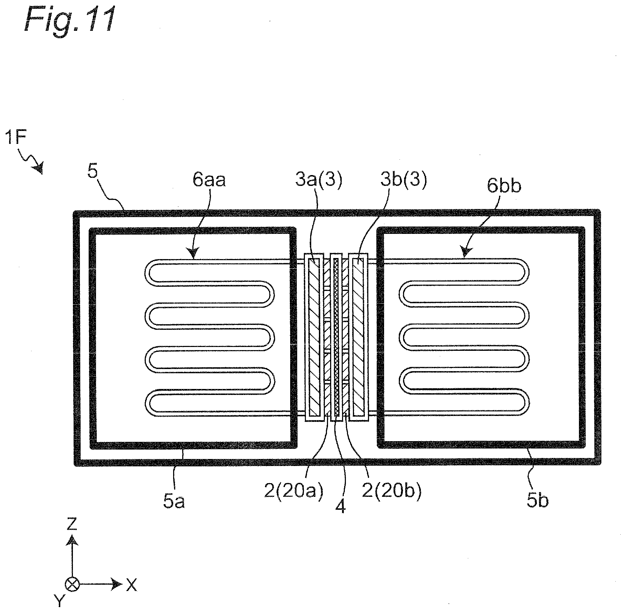

FIG. 11 shows a schematic structure of a thermoelectric power generation device IF related to Embodiment 6.

Embodiment 6 is different from Embodiment 1 in that partitions 5a, 5b are provided to define two passages in which the high temperature fluid flows, and that the thermoelectric elements 2 are provided on both sides of a cooling unit 4, and heating units 3 (3a, 3b) are provided on both sides of the cooling unit 4 with interposition of the thermoelectric elements 2.

As shown in FIG. 11, the thermoelectric power generation device IF includes partitions 5a, 5b defining two passages in which the high temperature fluid flows. In the thermoelectric power generation device 1F, the thermoelectric elements 2, the cooling unit 4, and the heating units 3 are provided between the two passages. Further, the thermoelectric elements 2 are provided on both sides of the cooling unit 4. The heating units 3 are provided on both sides of the cooling unit 4 so as to face each other across the thermoelectric elements 2.

In a first passage defined by the partition 5a, a first heat transfer pipe 6aa is arranged. The first heat transfer pipe 6aa is heated by the high temperature fluid flowing in the first passage. Therefore, the heating unit 3a on the side of the first passage heats the first side of the thermoelectric element 2 (thermoelectric module 20a) by using the heat of the high temperature fluid flowing in the first passage.

In a second passage defined by the partition 5b, a second heat transfer pipe 6ab is arranged. The second heat transfer pipe 6ab is heated by the high temperature fluid flowing in the second passage. Therefore, the heating unit 3b on the side of the second passage heats the first side of the thermoelectric element 2 (thermoelectric module 20a) by using the heat of the high temperature fluid flowing in the second passage.

The two heating units 3a, 3b are provided on both sides of the cooling unit 4 so as to face each other across the thermoelectric elements 2. In other words, the cooling unit 4 is sandwiched between the two heating units 3a, 3b with interposition of the thermoelectric elements 2. Therefore, the second sides of the thermoelectric elements 2 (thermoelectric module 20, 20b) are cooled by the cooling unit 4 sandwiched between the two heating units 3a, 3b.

### [Effects]

The thermoelectric power generation device 1F related to Embodiment 6 brings about the following effects.

With the thermoelectric power generation device 1F in which two passages are defined and arranging the heat transfer pipes 6aa, 6ab in the two passages, respectively, heat of the high temperature fluid flowing in the passage 5 can be efficiently used. Further, since power can be generated by using the two heating units 3a, 3b, an increase in the output can be achieved.

### (Embodiment 7)

### [Overall Structure]

A thermoelectric power generation device related to Embodiment 7 of the present invention is described. It should be noted that Embodiment 7 mainly describes differences from Embodiment 1. In Embodiment 7, the same symbols are given to structures identical or similar to those of Embodiment 1. Further, the description of Embodiment 7 omits descriptions which overlaps with that of Embodiment 1.

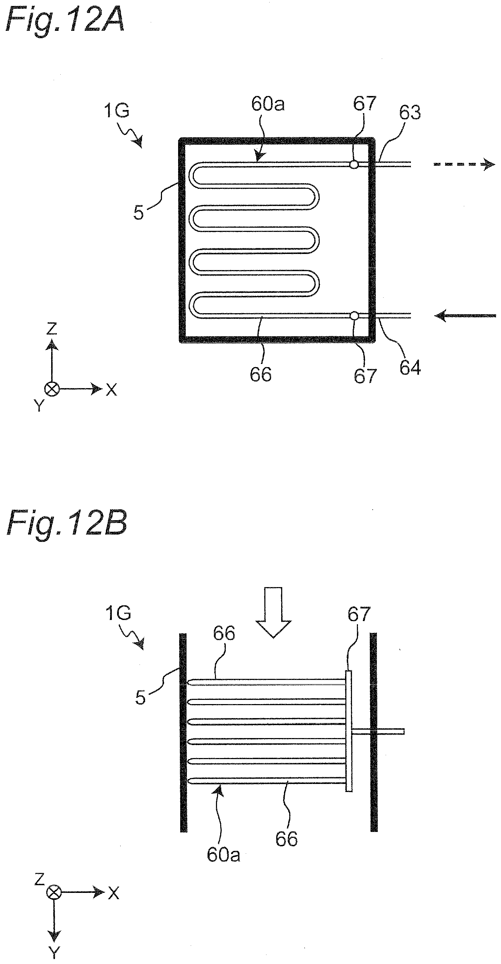

FIG. 12A shows a schematic structure of a heat transfer pipe 60a of a thermoelectric power generation device 1G related to Embodiment 7. FIG. 12B is a diagram showing a schematic structure of the heat transfer pipe 60a of the thermoelectric power generation device 1G when viewed in the height direction (in Z direction). The white arrow in FIG. 12B indicates the flowing direction of a high temperature fluid.

Embodiment 7 is different from Embodiment 1 in that the heat transfer pipe 60a includes a plurality of pipes 66 and a collecting pipe 67 joining the plurality of pipes 66.

As shown in FIG. 12A and FIG. 12B, the heat transfer pipe 60a includes the plurality of pipes 66 and the collecting pipe 67 joining the plurality of pipes 66. The plurality of pipes 66 are arranged one after another in the direction of the flow of the high temperature fluid, i.e., in the Y direction. The collecting pipe 67 has an open end portion 63 in a high position of the heat transfer pipe 60a, and an open end portion 64 in a low position of the heat transfer pipe 60a. The heat medium flowing from the heating unit 3 through the open end portion 64 can be supplied to the plurality of pipes 66 through the collecting pipe 67 on the low side of the heat transfer pipe 60a. Further, the heat medium flowing in the plurality of pipes 66 join together in the collecting pipe 67 on the high side of the heat transfer pipe 60a and flows to the open end portion 63.

### [Effects]

The thermoelectric power generation device 1G related to Embodiment 7 brings about the following effects.

With the thermoelectric power generation device 1G having a structure in which a plurality of pipes 66 are joined together by the collecting pipe 67, the pressures inside the plurality of pipes 66 can be equalized. Therefore, heat exchanger duty amongst the plurality of pipes 66 can be improved.

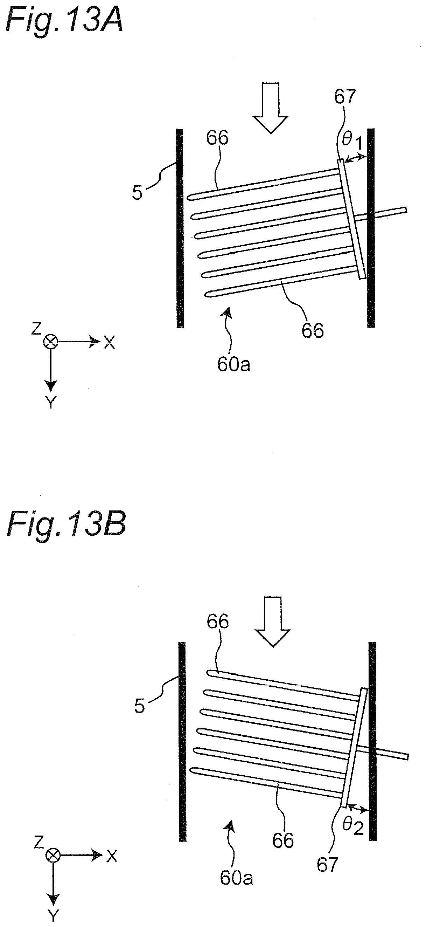

FIG. 13A shows a schematic structure of a modification of the thermoelectric power generation device 1G related to Embodiment 7. As shown in FIG. 13A, the heat transfer pipe 60a may be arranged so as to be inclined relative to a direction in which the high temperature fluid flows, as viewed from the height direction (Z direction). Specifically, the heat transfer pipe 60a is inclined at a predetermined angle θ1 from the upstream side to the downstream side of the passage 5. The predetermined angle θ1 is set so as to reduce the overlapping area of the plurality of pipes 66 arranged in the height direction (Z direction) when viewed from the Y direction. The predetermined angle θ1 is determined by the shape of the passage 5, the size of the passage 5, the size of the heat transfer pipe 60a, and the like. With this structure, an area of the pipes 66 on the downstream side overlapping with the pipes 66 on the upstream side as viewed from the Y direction can be reduced. Therefore, the high temperature fluid flowing in the passage 5 easily contacts the pipes 66 on the downstream side without being blocked by the pipes 66 on the upstream side. As the result, the heat exchanger duty amongst the plurality of pipes 66 can be improved. The direction of inclining the heat transfer pipe 60a may be any direction as long as the plurality of pipes 66 do not block the flow of the high temperature fluid. FIG. 13B shows a schematic structure of another modification of the thermoelectric power generation device 1G related to Embodiment 7. As shown in FIG. 13B, the heat transfer pipe 60a is inclined at a predetermined angle θ2 towards a direction opposite to the direction of inclining the heat transfer pipe 60a shown in FIG. 13A, i.e., from the downstream side to the upstream side of the passage 5. As in the predetermined angle θ1, the predetermined angle θ2 is also set so as to reduce the overlapping area of the plurality of pipes 66 arranged in the height direction (Z direction) when viewed from the Y direction. The predetermined angle θ2 is determined by the shape of the passage 5, the size of the passage 5, the size of the heat transfer pipe 60a, and the like. It should be noted that the heat transfer pipe 60a may be inclined in the Z direction, or in both the Y direction and the Z direction.

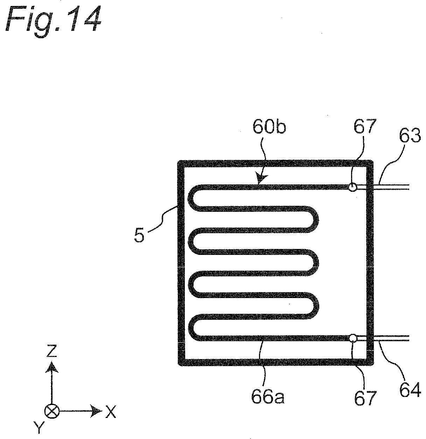

FIG. 14 shows a schematic structure of another modification of the thermoelectric power generation device 1G related to Embodiment 7. As shown in FIG. 14, the plurality of pipes 66a of the heat transfer pipe 60b may have a blackened outer surface. With this structure, recovery of radiant heat can be improved.

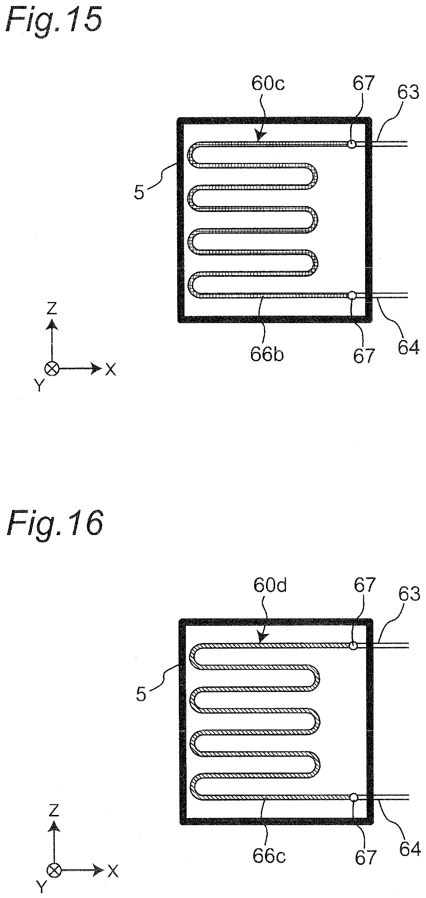

FIG. 15 shows a schematic structure of another modification of the thermoelectric power generation device 1G related to Embodiment 7. As shown in FIG. 15, the plurality of pipes 66b of the heat transfer pipe 60c may have a wick (capillary tube). As the wick, for example, a wire mesh can be used. With this structure, circulation of the heat medium inside the heat transfer pipe 60c can be induced.

FIG. 16 shows a schematic structure of another modification of the thermoelectric power generation device 1G related to Embodiment 7. As shown in FIG. 16, the plurality of pipes 66c of the heat transfer pipe 60d may have a groove. With this structure, circulation of the heat medium inside the heat transfer pipe 60d can be induced.

### (Embodiment 8)

### [Overall Structure]

A thermoelectric power generation device related to Embodiment 8 of the present invention is described. It should be noted that Embodiment 8 mainly describes differences from Embodiment 7. In Embodiment 8, the same symbols are given to structures identical or similar to those of Embodiment 7. Further, the description of Embodiment 8 omits descriptions which overlaps with that of Embodiment 7.

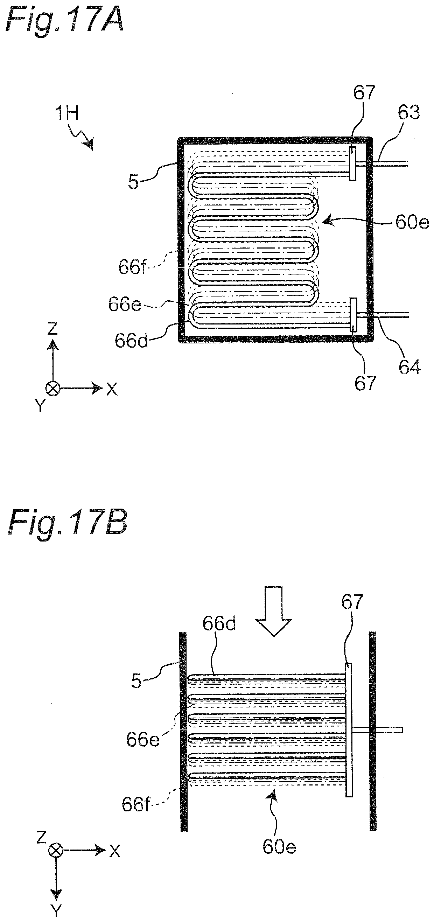

FIG. 17A shows a schematic structure of a heat transfer pipe 60e of a thermoelectric power generation device 1H related to Embodiment 8. FIG. 17B is a diagram showing a schematic structure of the heat transfer pipe 60e of the thermoelectric power generation device 1H when viewed in the height direction (Z direction). The white arrow in FIG. 17B indicates the flowing direction of a high temperature fluid.

Embodiment 8 is different from Embodiment 7 in that, when the thermoelectric power generation device 1H is viewed from the lateral direction (Y direction), a plurality of pipes 66d, 66e, 66f of the heat transfer pipe 60e are offset in the height direction (Z direction) of the thermoelectric power generation device 1H.

As shown in FIG. 17A and FIG. 17B, the plurality of pipes 66d, 66e, 66f are successively arranged from the upstream side to the downstream side of the passage 5. The plurality of pipes 66d, 66e, 66f are offset from one another in the height direction (Z direction) of the thermoelectric power generation device 1H when viewed from the lateral direction (Y direction) of the thermoelectric power generation device 1H so as to reduce an overlapping area.

### [Effects]

The thermoelectric power generation device 1H related to Embodiment 8 brings about the following effects.

The thermoelectric power generation device 1H has the plurality of pipes 66d, 66e, 66f offset from one another in the height direction (Z direction) of the thermoelectric power generation device 1H. With this structure, a problem of the pipe 66d on the upstream side blocking the flow of the high temperature fluid to the pipes 66e, 66f on the downstream side can be suppressed or reduced. This way, the heat transfer rate of the plurality of pipes 66d, 66e, 66f can be improved.

Although Embodiment 8 deals with a case where three pipes 66d, 66e, 66f are arranged and offset from one another in the height direction (Z direction) of the thermoelectric power generation device 1H, the present invention is not limited to this. For example, two or more pipes may be arranged and offset in the height direction (Z direction) of the thermoelectric power generation device 1H.

Although Embodiment 8 deals with a case where plurality of pipes 66d, 66e, 66f are arranged and offset from one another in the height direction (Z direction) of the thermoelectric power generation device 1H, the present invention is not limited to this. The similar effect is brought about by arranging the plurality of pipes 66d, 66e, 66f offset in the longitudinal direction (X direction) of the thermoelectric power generation device 1H.

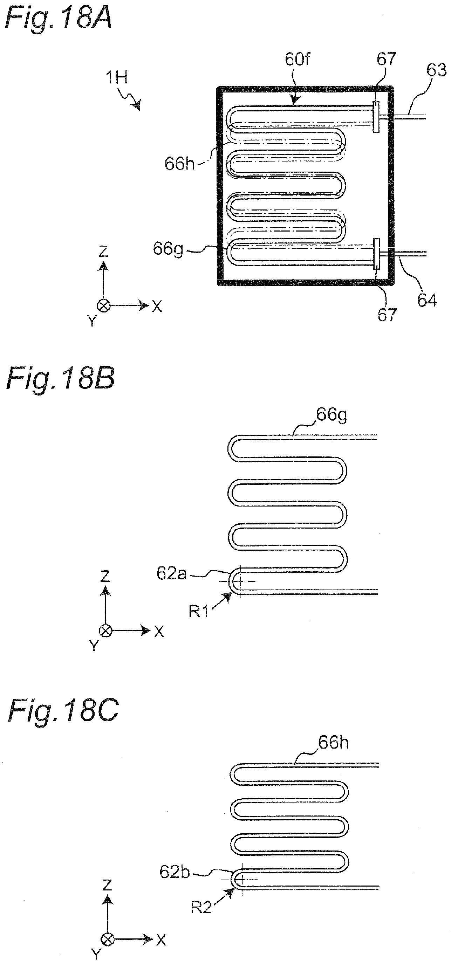

FIG. 18A shows a schematic structure of another modification of the thermoelectric power generation device 1H related to Embodiment 8. FIG. 18B shows a schematic structure of the pipe 66g on the upstream side of the heat transfer pipe 60f. FIG. 18C shows a schematic structure of the pipe 66h on the downstream side of the heat transfer pipe 60f. As shown in FIGS. 18A, 18B and 18C, a bend radius R1 of a bent portion 62a of the pipe 66g on the upstream side and the bend radius R2 of the bent portion 62b of the pipe 66h on the downstream side may be designed to be different. Specifically, the bend radius R2 of the bent portion 62b of the pipe 66h on the downstream side is designed to be smaller than the bend radius R1 of the bent portion 62a of the pipe 66g on the upstream side. With this structure, an area of the pipe 66h on the downstream side overlapping with the pipe 66g on the upstream side as viewed from the Y direction can be reduced. Therefore, the high temperature fluid flowing in the passage 5 easily contacts the pipes 66h on the downstream side. This way, the heat transfer rate of the plurality of pipes 66g, 66h can be improved. The same effect can be brought about by making the bend radius R2 of the bent portion 62b of the pipe 66h on the downstream side greater than the bend radius R1 of the bent portion 62a of the pipe 66g on the upstream side.

### (Embodiment 9)

### [Overall Structure]

A thermoelectric power generation device related to Embodiment 9 of the present invention is described. It should be noted that Embodiment 9 mainly describes differences from Embodiment 7. In Embodiment 9, the same symbols are given to structures identical or similar to those of Embodiment 7. Further, the description of Embodiment 9 omits descriptions which overlaps with that of Embodiment 7.

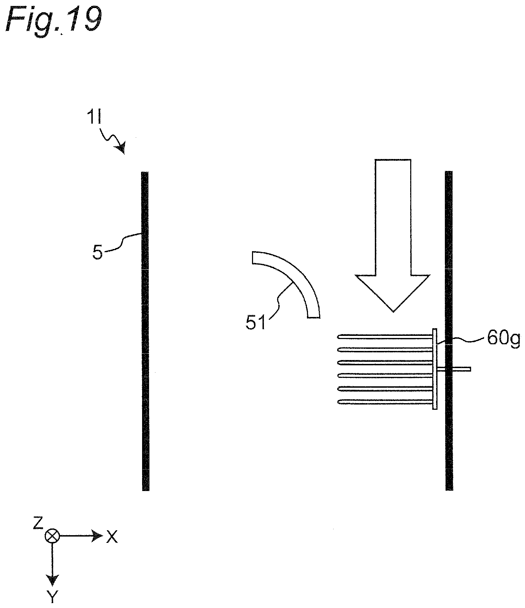

FIG. 19 shows a schematic structure of a heat transfer pipe 60g of a thermoelectric power generation device 1I related to Embodiment 9. FIG. 19 is a diagram showing a schematic structure of the thermoelectric power generation device 1I when viewed in the height direction (Z direction). The white arrow in FIG. 19 indicates the flowing direction of a high temperature fluid.

Embodiment 9 is different from Embodiment 7 in that the heat transfer pipe 60g is arranged in a portion of the passage 5, and the high temperature fluid is directed towards the heat transfer pipe 60g by a guide vane 51 provided in the passage 5.

When the passage 5 is relatively large for the heat transfer pipe 60g as shown in FIG. 19, the heat transfer pipe 60g is arranged in a portion of the passage 5. In this case, the guide vane 51 for changing the flow of the high temperature fluid is provided in the passage 5, and the high-temperature fluid is directed to the heat transfer pipe 60g by the guide vane 51.

### [Effects]

The thermoelectric power generation device 1I related to Embodiment 9 brings about the following effects.

With the thermoelectric power generation device 1I, even if the passage 5 is relatively large for the heat transfer pipe 60g, the high temperature fluid can be directed towards the heat transfer pipe 60g by the guide vane 51 provided in the passage 5. Therefore, even if the heat transfer pipe 60g is arranged in a portion of the passage 5, flow rate of the high temperature fluid flowing towards the heat transfer pipe 60g can be increased by the guide vane 51.

### (Embodiment 10)

### [Overall Structure]

A thermoelectric power generation system related to Embodiment 10 of the present invention is described. It should be noted that Embodiment 10 deals with a thermoelectric power generation system having the thermoelectric power generation devices 1A of Embodiment 1. In Embodiment 10, the same symbols are given to structures identical or similar to those of Embodiment 1. Further, the description of Embodiment 10 omits descriptions which overlaps with that of Embodiment 1.

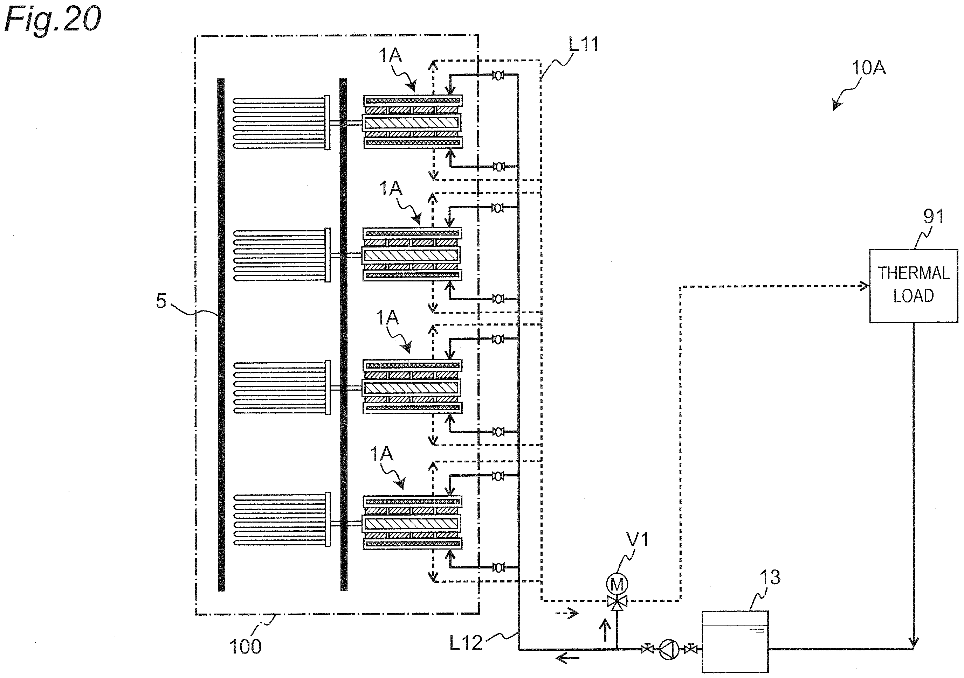

FIG. 20 shows a schematic structure of a thermoelectric power generation system 10A related to Embodiment 10. In FIG. 20, the dotted line shows a first coolant line L11 through which the heated coolant flows, and the solid line shows a second coolant line L12 through which the cooled coolant flows. As shown in FIG. 20, the thermoelectric power generation system 10A includes a thermoelectric power generation unit 100 and a thermal load 91. In Embodiment 10, the thermoelectric power generation unit 100 and the thermal load 91 are connected through the first coolant line L11 and the second coolant line L12. The second coolant line L12 is provided with a tank 13 for storing the coolant.

In Embodiment 10, water is used as the coolant. The water used as the coolant circulates between the thermoelectric power generation unit 100 and the thermal load 91 through the first coolant line L11 and the second coolant line L12. Specifically, the coolant sequentially flows in the thermoelectric power generation unit 100, the first coolant line L11, the thermal load 91, and the second coolant line L12.

### <Thermoelectric Power Generation Unit>

The thermoelectric power generation unit 100 is a unit including at least one thermoelectric power generation device 1A. Embodiment 10 deals with a case where the thermoelectric power generation unit 100 includes four thermoelectric power generation devices 1A. The thermoelectric power generation unit 100 generates power, for example, by utilizing the heat of the high temperature fluid flowing in the passage 5.

In Embodiment 10, the thermoelectric power generation unit 100 uses thermoelectric power generation devices 1A capable of handling high temperatures. The thermoelectric power generation devices 1A capable of handling high temperatures means, for example, thermoelectric power generation device with the limit temperature for using is 250°C. With the thermoelectric power generation device 1A capable of handling high temperatures, for example, the heating temperature of the heating unit 3 can be set to 230°C. Therefore, the tolerable temperature of the coolant can be about 80°C to 100°C. Therefore, in Embodiment 10, the coolant heated by the thermoelectric power generation unit 100 can be used as warm water or vapor.

The coolant heated by the thermoelectric power generation unit 100 is supplied to the thermal load 91 through the first coolant line L11. In Embodiment 10, the coolant flowing in the first coolant line L11 is supplied to the thermal load 91 as warm water or vapor.

### <Thermal Load>

The thermal load 91 is an installation that consumes the heat of the coolant heated by the thermoelectric power generation unit 100. Examples of the thermal load 91 include an office building, a hotel, a factory, a hospital, and the like. For example, the thermal load 91 uses the coolant (i.e., warm water or vapor) of about 80□ to 100□ supplied through the first coolant line L11 for hot water supply and heating. By consuming the heat of the coolant by the thermal load 91 as described, the temperature of the coolant can be lowered.

The coolant whose temperature is lowered by the thermal load 91 is again supplied to the thermoelectric power generation unit 100 through the second coolant line L12. In Embodiment 10, the coolant from the thermal load 91 is stored in the tank 13, and then supplied to the thermoelectric power generation unit 100.

Further, the coolant flowing in the second coolant line L12 may be supplied to the first coolant line L11 through a valve V1. By letting the coolant of the second coolant line L12 flow into the first coolant line L11 through the valve V1, the temperature of the coolant flowing in the first coolant line L11 can be adjusted.

For example, in a case where the thermal load 91 requires warm water of 40□, the coolant (e.g., water of about 20 □) flowing in the second coolant line L12 is supplied to the coolant (e.g. water of about 80□ to 100□) flowing in the first coolant line L11. This way, the temperature of the coolant flowing in the first coolant line L11 can be adjusted to about 40□. To adjust the temperature, a temperature measuring unit may be provided to the first coolant line L11 and the second coolant line L12.

### [Effects]

The thermoelectric power generation system 10A related to Embodiment 10 brings about the following effects.

Since the thermoelectric power generation system 10A includes the thermoelectric power generation unit 100 having at least one thermoelectric power generation device 1A, the effects similar to Embodiment 1 can be brought about. Specifically, the thermoelectric power generation system 10A can improve the power generation efficiency.

With the thermoelectric power generation system 10A, the heat of the coolant heated by the thermoelectric power generation unit 100 can be consumed by the thermal load 91. Specifically, the heat of the coolant can be used for hot water supply or heating by supplying the coolant heated by the thermoelectric power generation unit 100 to the thermal load 91. As described, since heat can be effectively used in addition to power generation with the thermoelectric power generation system 10A, the efficiency of using energy is improved.

With the thermoelectric power generation system 10A, there is no need for a cooling device for cooling the coolant heated by the thermoelectric power generation unit 100. Therefore, costs for installation can be reduced.

With the thermoelectric power generation system 10A, the temperature of the coolant can be increased by adopting a thermoelectric power generation device 1A capable of handling high temperatures. Therefore, the coolant can be supplied to the thermal load 91 in the form of warm water or vapor.

Although Embodiment 10 deals with a case where the thermoelectric power generation unit 100 includes four thermoelectric power generation devices 1A; the present invention is not limited to this, as long as the thermoelectric power generation unit 100 includes at least one thermoelectric power generation device 1A.

Although Embodiment 10 deals with a case where the thermoelectric power generation unit 100 uses thermoelectric power generation devices 1A capable of handling high temperatures; the present invention is not limited to this. The specification of the thermoelectric power generation device 1A may be determined according to the environment of applying the thermoelectric power generation system 10A.

Although Embodiment 10 deals with a case where the thermoelectric power generation unit 100 adopts the thermoelectric power generation device 1A of Embodiment 1; the present invention is not limited to this. For example, the thermoelectric power generation unit 100 may adopt the thermoelectric power generation devices 1B, 1C, 1D, 1F, 1G, 1H, 1I of Embodiment 2 to Embodiment 9.

Although Embodiment 10 deals with a case where the thermoelectric power generation system 10A includes the valve V1 and the tank 13, the present invention is not limited to this. The valve V1 and the tank 13 are not essential.

The temperature of the coolant and the heating temperature of the heating unit 3 mentioned in Embodiment 10 are examples, and the present invention is not limited to these.

### (Embodiment 11)

### [Overall Structure]

A thermoelectric power generation system related to Embodiment 11 of the present invention is described. It should be noted that Embodiment 11 mainly describes differences from Embodiment 10. In Embodiment 11, the same symbols are given to structures identical or similar to those of Embodiment 10. Further, the description of Embodiment 11 omits descriptions which overlaps with that of Embodiment 10.

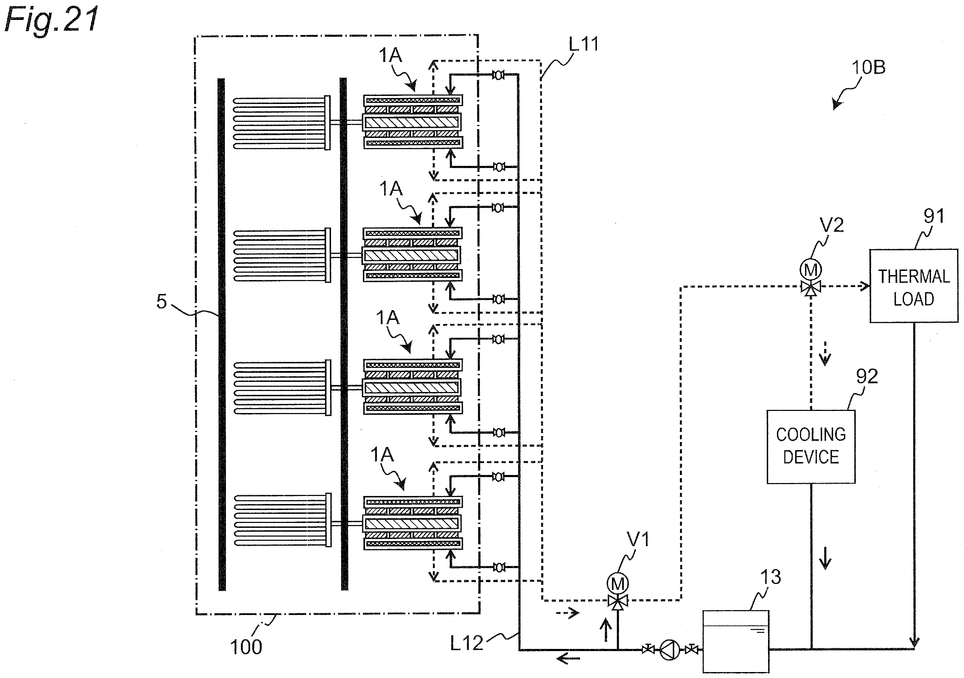

FIG. 21 shows a schematic structure of a thermoelectric power generation system 10B related to Embodiment 11. As shown in FIG. 21, Embodiment 11 is different from Embodiment 10 in that a cooling device 92 is provided.

### <Cooling Device>

The cooling device 92 is an installation for controlling the temperature of the coolant. The cooling device 92 is arranged between the first coolant line L11 and the second coolant line L12. The cooling device 92 cools the coolant heated by the thermoelectric power generation unit 100 flowing in the first coolant line L11 and supplies the cooled coolant to the second coolant line L12.

The cooling device 92 cools the coolant heated by the thermoelectric power generation unit 100, for example, when there is no need for heat in the thermal load 91. Specifically, when there is no need for heat in the thermal load 91, the passage is switched by a valve V2 provided in the first coolant line L11. This way, the coolant is supplied from the first coolant line L11 to the cooling device 92. The cooling device 92 cools the high temperature coolant (e.g., about 80°C) and supplies the coolant to the second coolant line L12.

For example, the valve V2 in Embodiment 11 is controlled by a computer and is controlled according to the need for heat in the thermal load 91. For example, if there is no need for heat in the thermal load 91, the valve V2 supplies the coolant flowing in the first coolant line L11 to the cooling device 92.

The cooling device 92 can lower the temperature of the coolant more than the temperature of the coolant lowered by heat consumption in the thermal load 91.

### [Effects]

The thermoelectric power generation system 10B related to Embodiment 11 brings about the following effects.

The thermoelectric power generation system 10B includes a cooling device 92 for controlling the temperature of the coolant. With this structure, if there is no need for heat in the thermal load 91, the valve V2 supplies the coolant flowing in the first coolant line L11 to the cooling device 92. Therefore, the coolant can be cooled by the cooling device 92. The cooling device 92 can lower the temperature of the coolant more than the cooling of the coolant by heat consumption in the thermal load 91. With this structure, by lowering the temperature of the coolant by the cooling device 92 when there is no need for heat in the thermal load 91, the temperature difference between the heat medium flowing the heating unit 3 and the coolant can be increased, and the amount of power generated can be improved.

Although Embodiment 11 deals with a case where the cooling device 92 lowers the temperature of the coolant, when there is no need for heat in the thermal load 91, the present invention is not limited to this. For example, the cooling device 92 may increase the temperature of the coolant when there is need for heat in the thermal load 91. As described, the cooling device 92 may adjust the temperature of the coolant to a temperature required by the thermal load 91.

### (Embodiment 12)

### [Overall Structure]

A thermoelectric power generation system related to Embodiment 12 of the present invention is described. It should be noted that Embodiment 12 mainly describes differences from Embodiment 10. In Embodiment 12, the same symbols are given to structures identical or similar to those of Embodiment 10. Further, the description of Embodiment 12 omits descriptions which overlaps with that of Embodiment 10.

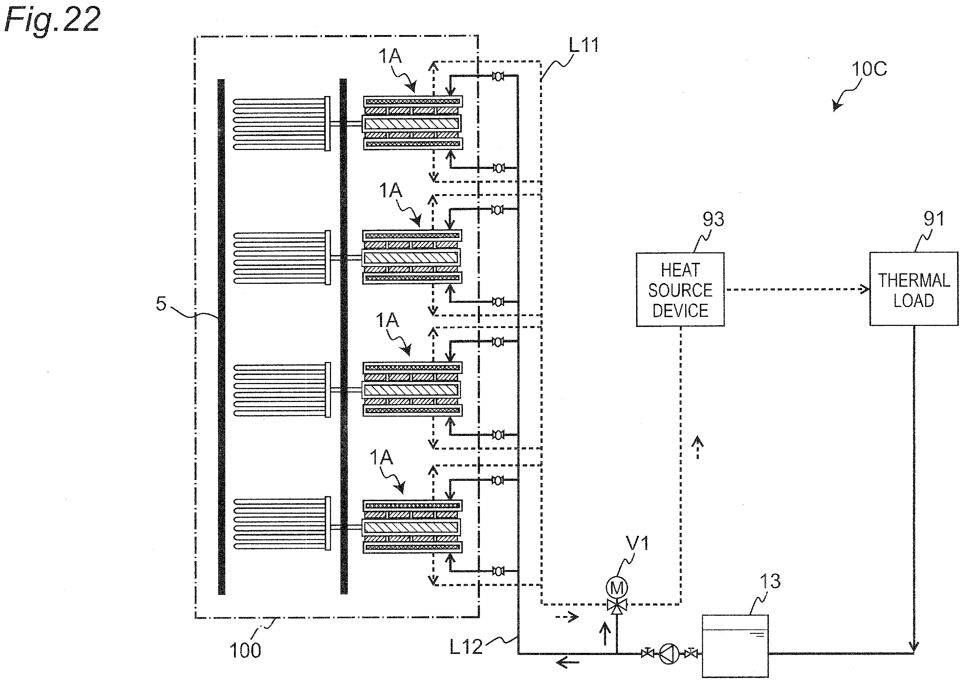

FIG. 22 shows a schematic structure of a thermoelectric power generation system 10C related to Embodiment 12. As shown in FIG. 22, Embodiment 12 is different from Embodiment 10 in that a heat source device 93 is provided.

### <Heat Source Device>

The heat source device 93 is an installation that heats the coolant heated by the thermoelectric power generation unit 100. Examples of the heat source device 93 include a cogeneration, a boiler, and the like. The heat source device 93 is arranged between the thermoelectric power generation unit 100 and the thermal load 91, and is connected to the first coolant line L11.

The coolant heated by the thermoelectric power generation unit 100 is supplied to the heat source device 93 through the first coolant line L11. The heat source device 93 further heats the coolant heated by the thermoelectric power generation unit 100, and supplies the coolant to the thermal load 91.

The coolant heated by the thermoelectric power generation unit 100 is used as water supply to the heat source device 93. For example, when the heat source device 93 is a cogeneration, the coolant of about 60°C flowing in the first coolant line L11 is heated to about 80°C to 100°C by using exhaust heat of the cogeneration. This way, the coolant is supplied to the thermal load 91 as warm water or vapor.

### [Effects]

The thermoelectric power generation system 10C related to Embodiment 12 brings about the following effects.

The thermoelectric power generation system 10C includes a heat source device 93 configured to heat the coolant heated by the thermoelectric power generation unit 100 and supply the coolant as warm water or vapor to the thermal load 91. With this structure, the coolant heated by the thermoelectric power generation unit 100 can be used as water supply to the heat source device 93. Therefore, efficiency in heat supply can be improved.

### (Embodiment 13)

### [Overall Structure]

A thermoelectric power generation system related to Embodiment 13 of the present invention is described. It should be noted that Embodiment 13 deals with another thermoelectric power generation system having the thermoelectric power generation devices 1A of Embodiment 1. In Embodiment 13, the same symbols are given to structures identical or similar to those of Embodiment 1. Further, the description of Embodiment 13 omits descriptions which overlaps with that of Embodiment 1.

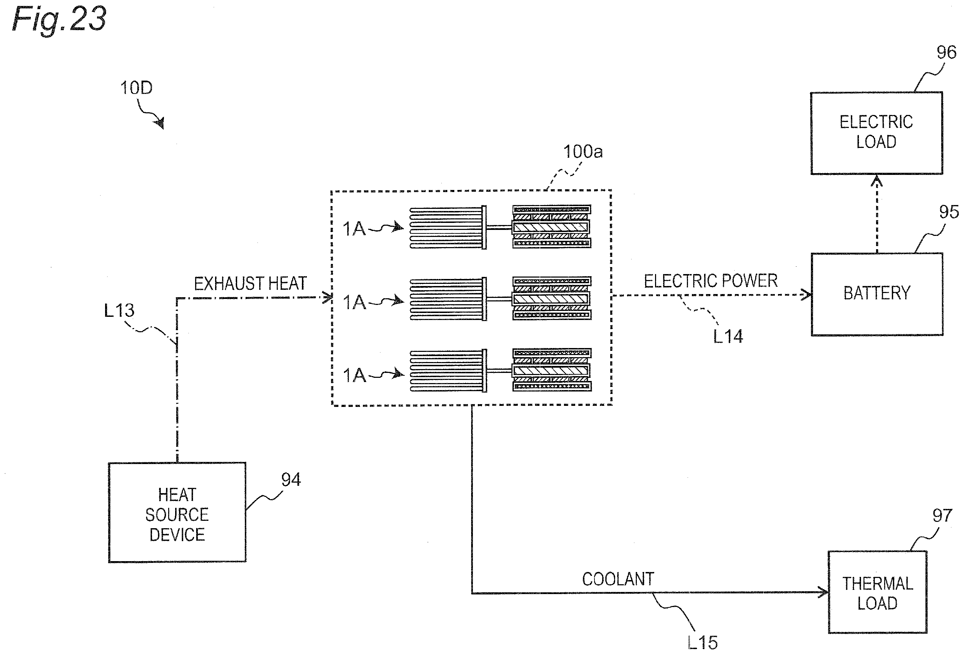

FIG. 23 shows a schematic structure of a thermoelectric power generation system 10D related to Embodiment 13. As shown in FIG. 23, the thermoelectric power generation system 10D includes a thermoelectric power generation unit 100a, a heat source device 94, a battery 95, an electric load 96, and a thermal load 97.

### < Thermoelectric Power Generation Unit>

The thermoelectric power generation unit 100a is a unit including at least one thermoelectric power generation device 1A. Embodiment 13 deals with a case where the thermoelectric power generation unit 100a includes three thermoelectric power generation devices 1A. The thermoelectric power generation unit 100a generates power, for example, by using exhaust heat of the heat source device 94.

### <Heat Source Device>

The heat source device 94 is an installation for generating heat and is, for example, a cogeneration, a boiler, and the like. In Embodiment 13, the heat source device 94 is a cogeneration and, for example, generates exhaust gas of about 357°C through generation of power. For example, the thermoelectric power generation unit 100a is arranged in an exhaust gas line L13 in which the exhaust gas flows, and generates electricity using heat (exhaust heat) of the exhaust gas.

### <Battery>

The battery 95 stores electric power generated by the thermoelectric power generation unit 100. The battery 95 is electrically connected to the thermoelectric power generation unit 100a. The electric power generated by the thermoelectric power generation unit 100a is supplied to and stored in the battery 95 through an electric power supply line L14. The battery 95 supplies electric power stored to the electric load 96.

### <Electric Load>

The electric load 96 is an installation for consuming electric power stored in the battery 95. Examples of the electric load 96 include an office building, a hotel, a factory, a hospital, and the like. The electric load 96 is electrically connected to the battery 95, and receives electric power supplied from the battery 95 according to the need of electric power.

### <Thermal Load>

The thermal load 97 is an installation that consumes the heat of the coolant heated by the thermoelectric power generation unit 100a. Examples of the thermal load 97 include an office building, a hotel, a factory, a hospital, and the like. The thermal load 97 is connected to the thermoelectric power generation unit 100a through a coolant line. The coolant heated by the thermoelectric power generation unit 100a is supplied to the thermal load 97 through a coolant line L15. For example, the thermal load 97 uses the coolant heated by the thermoelectric power generation unit 100a (e.g., warm water or vapor) for hot water supply and heating.

### [Effects]

The thermoelectric power generation system 10D related to Embodiment 13 brings about the following effects.

With the thermoelectric power generation system 10D, the battery 95 can store electric power generated by the thermoelectric power generation unit 100a by using exhaust heat of the heat source device 94, and warm water or vapor can be supplied to the thermal load 97. That is, with the thermoelectric power generation system 10, the thermoelectric power generation unit 100a can be turned into a cogeneration. Therefore, power generation efficiency can be improved, and the exhaust heat can be effectively used to provide warm water or vapor.

With the thermoelectric power generation system 10D having the battery 95, electric power can be supplied to the electric load 96 according to the need for electric power.

Although Embodiment 13 deals with a case where the coolant heated by the thermoelectric power generation unit 100a is supplied to the thermal load 97, the present invention is not limited to this. For example, the coolant heated by the thermoelectric power generation unit 100a may be used as water supply to the heat source device.

Although Embodiment 13 deals with a case where the thermoelectric power generation system 10D includes the battery 95, the present invention is not limited to this. For example, the thermoelectric power generation system 10D may directly supply, to the electric load 96, the electric power generated by the thermoelectric power generation unit 100a.

Although each of the above embodiments describes the present invention with a certain level of details, the details of the structures disclosed in these embodiments are modifiable. Further, modification in combinations and arrangement of elements in each embodiment are possible without departing from the scope and spirit of the present disclosure.

### Industrial Applicability

The present invention improves power generation efficiency by using both sides of a heating unit for generating electric power. Therefore, the present invention is useful for a thermoelectric power generation device and a thermoelectric power generation system which generate electric power by using heat of a high temperature fluid flowing in a passage such as an exhaust gas duct of an engine. In addition to the exhaust gas duct of an engine, the present invention is also useful for a thermoelectric power generation device and a thermoelectric power generation system which generate electric power in a high temperature environment such as a disposal furnace or a biomass boiler, or in a radiation field not requiring convection.

### Reference Signs List

1A, 1B, 1C, 1D, 1F, 1G, 1H, 1I thermoelectric power generation device
10, 10A, 10B, 10C, 10D thermoelectric power generation system
11 inverter
12 electric load
13 tank
14 vacuum pump
15 heat exchanger
16 cooling installation
2 thermoelectric element
20a, 20b thermoelectric module
3, 3a, 3b heating unit
4, 4a, 4b cooling unit
40, 40a, 40b coolant passage
41 coolant inflow pipe
42 coolant discharge pipe
43 uneven portion
44 fin
5 passage
51 guide vane
6, 6a, 60a, 60b, 60c, 60d, 60e, 60f, 60g heat transfer pipe
61 tubular member
62 bent portion
63 open end portion
64 open end portion
65 pressure equalizer
66, 66a, 66b, 66c, 66d, 66e, 66f, 66g, 66h pipe
67 collecting pipe
7 circulation path
8a, 8b anti-deformation member
91 thermal load
92 cooling device
93 heat source device
94 heat source device
95 battery
96 electric load
97 thermal load
100 thermoelectric power generation unit
L1, L2, L3 heat medium line
L4, L5 coolant line
L11, L12 coolant line
L13 exhaust gas line
L14 electric power supply line
L15 coolant line
R1, R2 bend radius

## Claims

1. A thermoelectric power generation device comprising:
thermoelectric elements having their first sides provided to a heating unit and their second sides provided to cooling units,
wherein
the thermoelectric elements are provided on both sides of the heating unit, and
the cooling units are provided on both sides of the heating unit so as to face each other across the thermoelectric elements.

2. The thermoelectric power generation device according to claim 1, comprising a heat transfer pipe arranged in a passage in which a high temperature fluid flows,
wherein
the heating unit and the heat transfer pipe have internal spaces communicating with each other,
the internal space of the heating unit and the internal space of the heat transfer pipe form a circulation path in which a heat medium is circulated,
the heat transfer pipes vaporize the heat medium flowing in the circulation path by using heat of the high temperature fluid, and
the heating unit condenses the heat medium vaporized.

3. The thermoelectric power generation device according to claim 2, wherein the thermoelectric elements, the heating unit, and the cooling units are arranged in a direction intersecting a direction in which the heat transfer pipe is extended.

4. The thermoelectric power generation device according to any one of claims 1 to 3, comprising a first anti-deformation member which sandwiches an end portion of the heating unit and an end portion of the cooling units.

5. The thermoelectric power generation device according to any one of claims 1 to 4, comprising a second anti-deformation member penetrating through and joining together the end portions of the cooling units facing each other.

6. The thermoelectric power generation device according to any one of claims 1 to 5, wherein the cooling units each has a plurality of uneven portions in a coolant passage in which a coolant flows.

7. The thermoelectric power generation device according to any one of claims 1 to 6, wherein the cooling units each has a plurality of fins in a coolant passage in which a coolant flows.

8. The thermoelectric power generation device according to claim 1, wherein a plurality of the heating units and the plurality of cooling units are alternately arranged with the thermoelectric elements interposed therebetween, and the cooling units are arranged on both ends.

9. Thermoelectric power generation device according to claim 8, further comprising a plurality of heat transfer pipes arranged in a passage in which the high temperature fluid flows,
wherein
the heating units and the heat transfer pipes have internal spaces communicating with one another,
the internal spaces of the heating units and the internal spaces of the heat transfer pipes form a circulation path in which a heat medium is circulated,
the internal spaces of the plurality of the heat transfer pipes are in communication through a pressure equalizer,
the heat transfer pipes vaporize the heat medium flowing in the circulation path by using heat of the high temperature fluid, and
each of the heating units condenses the heat medium vaporized.

10. The thermoelectric power generation device according to claim 8, comprising a heat transfer pipe arranged in a passage in which a high temperature fluid flows,
wherein
the heating units and the heat transfer pipe have internal spaces communicating with each other,
the internal spaces of the heating units and the internal space of the heat transfer pipe form a circulation path in which a heat medium is circulated,
the plurality of heating units share the heat transfer pipe,
the heat transfer pipe vaporizes the heat medium flowing in the circulation path by using heat of the high temperature fluid, and
each of the heating units condenses the heat medium vaporized.

11. The thermoelectric power generation device according to claim 2, wherein the heat transfer pipe includes a plurality of pipes, and a collecting pipe joining the plurality of pipes.

12. The thermoelectric power generation device according to claim 11, wherein the heat transfer pipe is arranged so as to be inclined relative to a direction in which the high temperature fluid flows.

13. The thermoelectric power generation device according to claim 11, wherein the plurality of pipes are offset from each other relative to a height direction of the heat transfer pipe, as viewed from a direction in which the high temperature fluid flows.

14. The thermoelectric power generation device according to any one of claims 11 to 13, wherein
the plurality of pipes respectively have bent portions, and
the bent portions of the plurality of pipes have different bend radii.

15. The thermoelectric power generation device according to any one of claims 2 and 11 to 14, wherein the heat transfer pipe has a blackened outer surface.

16. The thermoelectric power generation device according to any one of claims 2 and 11 to 15, wherein a wick is provided on an inner wall of the heat transfer pipe.

17. The thermoelectric power generation device according to any one of claims 2 and 11 to 15, wherein a groove is provided on an inner wall of the heat transfer pipe.

18. The thermoelectric power generation device according to any one of claims 2 and 11 to 17, wherein
the heat transfer pipe is provided in a part of a passage having a guide vane, and the high temperature fluid flowing in the passage is directed towards the heat transfer pipe by the guide vane.

19. A thermoelectric power generation device comprising:
thermoelectric elements having their first sides provided to heating units and their second sides provided to a cooling unit; and
a partition defining two passages in which a high temperature fluid flows, wherein
the thermoelectric elements, the cooling unit, and the heating units are provided between the two passages;
the thermoelectric elements are provided on both sides of the cooling unit; and
the heating units are provided on both sides of the cooling unit so as to face each other across the thermoelectric element.

20. A thermoelectric power generation system, comprising:
a thermoelectric power generation unit having at least one thermoelectric power generation device; and
a thermal load which consumes heat of a heat medium heated by the thermoelectric power generation unit,
wherein
the thermoelectric power generation device includes thermoelectric elements having their first sides provided to a heating unit and their second sides provided to cooling units,
the thermoelectric elements are provided on both sides of the heating unit, and
the cooling units are provided on both sides of the heating unit so as to face each other across the thermoelectric elements.
